# EUROPEAN PATENT APPLICATION

(11) **EP 4 622 097 A1**
(43) Date of publication of application: **24.09.2025**
(21) Application number: 22966907.2
(22) Date of filing: 01.12.2022
(51) Int. Cl.: H03D 7/16, H04L 27/00

(54) **SIGNAL PROCESSING SYSTEM AND RELATED DEVICE**

(71) Applicant: Shenzhen Yinwang Intelligent Technologies Co., Ltd., Shenzhen, Guangdong 518129 (CN)
(72) Inventor: CHANG, Guanghong, Shenzhen, Guangdong 518129 (CN); CHENG, Zhiwen, Shenzhen, Guangdong 518129 (CN); LI, Ting, Shenzhen, Guangdong 518129 (CN)
(74) Representative: Maiwald GmbH
(86) International application number: PCT/CN2022/135969
(87) International publication number: WO 2024/113318

(57) **Abstract**

This application discloses a signal processing system and a related apparatus, and relates to the field of millimeter-wave radar technologies. The signal processing system includes: a signal generation unit, a frequency mixing and phase shifting unit, and N transmit ports, where the signal generation unit is configured to generate one baseband signal, where the one baseband signal includes a first baseband signal and a second baseband signal, and the first baseband signal and the second baseband signal are quadrature signals; the frequency mixing and phase shifting unit is configured to perform frequency mixing processing and phase shifting processing on the one baseband signal to obtain N radio frequency signals, where phases or frequencies of the N radio frequency signals are different from each other; and the N transmit ports are configured to respectively transmit the N radio frequency signals, where N is a positive integer. The signal processing system can solve problems of poor linearity and long settling time.

## Description

### TECHNICAL FIELD

This application relates to the field of millimeter-wave radar technologies, and in particular, to a signal processing system and a related apparatus.

### BACKGROUND

A millimeter-wave radar is a radar that operates in a millimeter-wave band for detection. The millimeter-wave radar measures information such as a range, a speed, and an orientation (angle) of a target by transmitting an electromagnetic wave signal and listening to, from an environment, a reflected signal of the electromagnetic wave signal reflected by the target.

Currently, a millimeter-wave radar mainly uses an analog modulated radar (analog modulated radar, AMR). A transmit end of the radar implements a linear change of a frequency of a sent signal by using a voltage-controlled oscillator and a phase-locked loop, and may generate and send a frequency modulated continuous wave (frequency modulated continuous wave, FMCW), a frequency shift keying (frequency shift keying, FSK) wave, a single-tone continuous wave (continuous wave, CW), and the like.

However, the current analog modulated radar has problems of poor linearity and long settling time.

### SUMMARY

Embodiments of this application provide a signal processing system and a related apparatus, to solve problems of poor linearity and long settling time.

According to a first aspect, an embodiment of this application provides a signal processing system, where the signal processing system includes:
a signal generation unit, a frequency mixing and phase shifting unit, and N transmit ports, where
the signal generation unit is configured to generate one baseband signal, where the one baseband signal includes a first baseband signal and a second baseband signal, and the first baseband signal and the second baseband signal are quadrature signals;
the frequency mixing and phase shifting unit is configured to perform frequency mixing processing and phase shifting processing on the one baseband signal to obtain N radio frequency signals, where phases or frequencies of the N radio frequency signals are different from each other; and
the N transmit ports are configured to respectively transmit the N radio frequency signals, where N is a positive integer.

In this embodiment of this application, a signal processing system is provided. A signal generation unit in the signal processing system is configured to generate one baseband signal, and the one baseband signal includes a first baseband signal and a second baseband signal that are orthogonal to each other. A frequency mixing and phase shifting unit in the signal processing system is configured to process the one baseband signal, to be specific, perform frequency mixing processing and phase shifting processing on the first baseband signal and the second baseband signal to obtain N radio frequency signals, and transmit the N radio frequency signals through N transmit ports in the signal processing system. Phases or frequencies of the N radio frequency signals are different from each other. Through the foregoing signal processing, the generated N radio frequency signals may have any waveforms, and there is no feedback adjustment of an analog device in a generation process, so that good linearity and short settling time can be implemented, thereby solving problems that a current analog modulated radar has poor linearity and long settling time.

In a possible implementation, the N radio frequency signals are frequency modulated continuous wave FMCW signals, and the N radio frequency signals meet a first pulse repetition interval PRI; or
the N radio frequency signals are phase modulated continuous wave PMCW signals, and the N radio frequency signals meet a second pulse repetition interval PRI.

In an implementation of this application, possible forms of the N radio frequency signals are provided. Specifically, the N radio frequency signals generated by the frequency mixing and phase shifting unit in the signal processing system may be frequency modulated continuous wave (frequency modulated continuous wave, FMCW) signals or phase modulated continuous wave (phase modulated continuous wave, PMCW) signals. The N radio frequency signals meet any pulse repetition interval (pulse repetition interval, PRI), and can implement a radio frequency signal of any waveform, thereby solving a problem that a radio frequency signal with a small PRI cannot be generated due to poor linearity of a current analog modulated radar.

In a possible implementation, the first baseband signal is an in-phase signal, and the second baseband signal is a quadrature signal.

In an implementation of this application, a possible specific implementation of the first baseband signal and the second baseband signal is provided. Specifically, the first baseband signal is an in-phase (in-phase) signal, and the second baseband signal is a quadrature (quadrature) signal.

In a possible implementation, the frequency mixing and phase shifting unit includes:
a first frequency mixing unit and a first phase shifting unit;
the first frequency mixing unit is configured to perform frequency mixing processing on the one baseband signal to obtain a first frequency-mixed signal; and
the first phase shifting unit is configured to perform phase shifting processing on the first frequency-mixed signal to obtain the N radio frequency signals.

In an implementation of this application, a possible specific implementation of the frequency mixing and phase shifting unit is provided. Specifically, the first frequency mixing unit in the frequency mixing and phase shifting unit is configured to perform frequency mixing processing on the one baseband signal generated by the signal generation unit, which may be specifically performing frequency mixing processing on the first baseband signal and a first local-oscillator signal, to obtain a first frequency-mixed signal. The first phase shifting unit in the frequency mixing and phase shifting unit is configured to perform phase shifting processing on the first frequency-mixed signal to obtain the N radio frequency signals. Phases or frequencies of the N radio frequency signals are different from each other. In the foregoing manner of first performing frequency mixing processing and then phase shifting processing, the generated N radio frequency signals may have any waveforms, and there is no feedback adjustment of an analog device in a generation process, so that good linearity and short settling time can be implemented.

In a possible implementation, the first frequency mixing unit includes a first frequency mixing module, and the first frequency mixing module includes:
a first frequency mixer and a second frequency mixer;
the first frequency mixer is configured to perform frequency mixing processing on the first baseband signal and a first local-oscillator signal; and
the second frequency mixer is configured to perform frequency mixing processing on the second baseband signal and the first local-oscillator signal.

In an implementation of this application, a possible specific implementation of the first frequency mixing unit is provided. Specifically, the first frequency mixer included in the first frequency mixing module in the first frequency mixing unit is configured to perform frequency mixing processing on the first baseband signal and the first local-oscillator signal, and the second frequency mixer included in the first frequency mixing module in the first frequency mixing unit is configured to perform frequency mixing processing on the second baseband signal and the first local-oscillator signal. The first frequency mixer and the second frequency mixer may be two frequency mixers independent of each other, or may be two frequency mixing components in one IQ frequency mixer. The first frequency mixer and the second frequency mixer included in the first frequency mixing module may be used to perform frequency mixing processing on the one baseband signal (including the first baseband signal and the second baseband signal), and then output the first frequency-mixed signal.

In a possible implementation, the first phase shifting unit includes:
N phase shifters; and
the N phase shifters are configured to respectively perform phase shifting processing on N frequency-mixed sub-signals corresponding to the first frequency-mixed signal, to obtain the N radio frequency signals.

In an implementation of this application, a possible specific implementation of the first phase shifting unit is provided. Specifically, the N phase shifters in the first phase shifting unit are configured to respectively perform phase shifting processing on the N frequency-mixed sub-signals corresponding to the first frequency-mixed signal obtained by the first frequency mixing unit, to obtain the N radio frequency signals. N corresponding frequency-mixed sub-signals may be obtained after the first frequency-mixed signal undergoes power splitting, the N frequency-mixed sub-signals are the same, and phases or frequencies of N corresponding radio frequency signals obtained after respective phase shifting processing are different from each other. The N phase shifters included in the first phase shifting unit may be used to implement a radio frequency signal of any waveform, and there is no feedback adjustment of an analog device in a generation process, so that good linearity and short settling time can be implemented, thereby solving problems that a current analog modulated radar has poor linearity and long settling time.

In a possible implementation, the frequency mixing and phase shifting unit includes:
a second phase shifting unit and a second frequency mixing unit;
the second phase shifting unit is configured to perform phase shifting processing on a first local-oscillator signal to obtain N phase-shifted signals; and
the second frequency mixing unit is configured to separately perform frequency mixing processing on N baseband sub-signals corresponding to the one baseband signal and the N phase-shifted signals, to obtain the N radio frequency signals.

In an implementation of this application, a possible specific implementation of the frequency mixing and phase shifting unit is provided. Specifically, the second phase shifting unit in the frequency mixing and phase shifting unit is configured to perform phase shifting processing on the first local-oscillator signal to obtain the N phase-shifted signals, where phases of the N phase-shifted signals are different from each other. The second frequency mixing unit in the frequency mixing and phase shifting unit is configured to separately perform frequency mixing processing on the N baseband sub-signals corresponding to the one baseband signal generated by the signal generation unit and the N phase-shifted signals, which may be specifically performing frequency mixing processing on one baseband sub-signal of the N baseband sub-signals and one phase-shifted signal of the N phase-shifted signals to obtain N radio frequency signals, where phases or frequencies of the N radio frequency signals are different from each other. In the foregoing manner of first performing phase shifting processing and then frequency mixing processing, the generated N radio frequency signals may have any waveforms, and there is no feedback adjustment of an analog device in a generation process, so that good linearity and short settling time can be implemented.

In a possible implementation, the second phase shifting unit includes:
N phase shifters; and
the N phase shifters are configured to respectively perform phase shifting processing on N local-oscillator sub-signals corresponding to the first local-oscillator signal, to obtain the N phase-shifted signals.

In an implementation of this application, a possible specific implementation of the second phase shifting unit is provided. Specifically, the N phase shifters in the second phase shifting unit are configured to respectively perform phase shifting processing on the N local-oscillator sub-signals corresponding to the first local-oscillator signal, to obtain the N phase-shifted signals, where N corresponding local-oscillator sub-signals may be obtained after the first local-oscillator signal undergoes power splitting, and the N local-oscillator sub-signals are the same. The N phase shifters included in the second phase shifting unit may be used to implement an effect that phases of the N corresponding phase-shifted signals obtained after respective phase shifting processing are different from each other.

In a possible implementation, the second frequency mixing unit includes N frequency mixing modules, and a second frequency mixing module in the N frequency mixing modules includes:
a third frequency mixer and a fourth frequency mixer;
the third frequency mixer is configured to perform frequency mixing processing on a first baseband sub-signal corresponding to the first baseband signal and a first phase-shifted signal in the N phase-shifted signals; and
the fourth frequency mixer is configured to perform frequency mixing processing on a second baseband sub-signal corresponding to the second baseband signal and the first phase-shifted signal.

In an implementation of this application, a possible specific implementation of the second frequency mixing unit is provided. Specifically, the third frequency mixer included in the second frequency mixing module in the second frequency mixing unit is configured to perform frequency mixing processing on the first baseband sub-signal corresponding to the first baseband signal and the first phase-shifted signal in the N phase-shifted signals obtained by the second phase shifting unit, the fourth frequency mixer included in the second frequency mixing module in the second frequency mixing unit is configured to perform frequency mixing processing on the second baseband sub-signal corresponding to the second baseband signal and the first phase-shifted signal in the N phase-shifted signals obtained by the second phase shifting unit. The third frequency mixer and the fourth frequency mixer may be two frequency mixers independent of each other, or may be two frequency mixing components in one IQ frequency mixer. The first baseband sub-signal corresponding to the first baseband signal may be one first baseband sub-signal of N first baseband sub-signals obtained after the first baseband signal undergoes power splitting, and the N first baseband sub-signals are the same. The second baseband sub-signal corresponding to the second baseband signal may be one second baseband sub-signal of N second baseband sub-signals obtained after the second baseband signal undergoes power splitting, and the N second baseband sub-signals are the same. One radio frequency signal of any waveform may be output by using the third frequency mixer and the fourth frequency mixer that are included in the second frequency mixing module. The N frequency mixing modules in the second frequency mixing unit include the second frequency mixing module, so that phases or frequencies of N output radio frequency signals of any waveforms are different from each other. In addition, there is no feedback adjustment of an analog device in a generation process, so that good linearity and short settling time can be implemented, thereby solving problems of poor linearity and long settling time in a current analog modulated radar.

In a possible implementation, the frequency mixing and phase shifting unit includes:
a third phase shifting unit and a third frequency mixing unit;
the third phase shifting unit is configured to perform phase shifting processing on the first baseband signal to obtain N first phase-shifted signals, and perform phase shifting processing on the second baseband signal to obtain N second phase-shifted signals; and
the third frequency mixing unit is configured to separately perform frequency mixing processing on the N first phase-shifted signals and the N second phase-shifted signals, to obtain the N radio frequency signals.

In an implementation of this application, a possible specific implementation of the frequency mixing and phase shifting unit is provided. Specifically, the third phase shifting unit in the frequency mixing and phase shifting unit is configured to: perform phase shifting processing on the first baseband signal to obtain the N first phase-shifted signals, and perform phase shifting processing on the second baseband signal to obtain the N second phase-shifted signals, where phases of the N first phase-shifted signals are different from each other, and phases of the N second phase-shifted signals are different from each other. The third frequency mixing unit in the frequency mixing and phase shifting unit is configured to separately perform frequency mixing processing on the N first phase-shifted signals and the N second phase-shifted signals that are obtained by the third phase shifting unit, which may be specifically separately performing frequency mixing processing on one first phase-shifted signal of the N first phase-shifted signals and one second phase-shifted signal of the N second phase-shifted signals, to obtain N radio frequency signals, where phases or frequencies of the N radio frequency signals are different from each other. In the foregoing manner of first performing phase shifting processing and then frequency mixing processing, the generated N radio frequency signals may have any waveforms, and there is no feedback adjustment of an analog device in a generation process, so that good linearity and short settling time can be implemented.

In a possible implementation, the third phase shifting unit includes:
2N phase shifters;
a (2i-1)^{th} phase shifter in the 2N phase shifters is configured to separately perform phase shifting processing on N baseband sub-signals corresponding to the first baseband signal to obtain the N first phase-shifted signals;
a 2i^{th} phase shifter in the 2N phase shifters is configured to separately perform phase shifting processing on N baseband sub-signals corresponding to the second baseband signal to obtain the N second phase-shifted signals; and
i is a positive integer less than or equal to N.

In an implementation of this application, a possible specific implementation of the third phase shifting unit is provided. Specifically, the (2i-1)^{th} phase shifter in the 2N phase shifters in the third phase shifting unit is configured to separately perform phase shifting processing on the N baseband sub-signals corresponding to the first baseband signal to obtain the N first phase shift signals, and the 2i^{th} phase shifter in the 2N phase shifters is configured to separately perform phase shifting processing on the N baseband sub-signals corresponding to the second baseband signal to obtain the N second phase-shifted signals. N corresponding baseband sub-signals may be obtained after the first baseband signal undergoes power splitting, the N baseband sub-signals are the same, and phases of N first phase-shifted signals obtained after respective phase shifting processing are different from each other. N corresponding baseband sub-signals may be obtained after the second baseband signal undergoes power splitting, the N baseband sub-signals are the same, and phases of N second phase-shifted signals obtained after respective phase shifting processing are different from each other. The 2N phase shifters included in the third phase shifting unit may be used to implement an effect that the phases of the N first phase-shifted signals obtained after respective phase shifting processing are different from each other and an effect that the phases of the N second phase-shifted signals obtained after respective phase shifting processing are different from each other.

In a possible implementation, the third frequency mixing unit includes N frequency mixing modules, and a third frequency mixing module in the N frequency mixing modules includes:
a fifth frequency mixer and a sixth frequency mixer;
the fifth frequency mixer is configured to perform frequency mixing processing on a first local-oscillator signal and one first phase-shifted signal of the N first phase-shifted signals; and
the sixth frequency mixer is configured to perform frequency mixing processing on the first local-oscillator signal and one second phase-shifted signal of the N second phase-shifted signals.

In an implementation of this application, a possible specific implementation of the third frequency mixing unit is provided. Specifically, the fifth frequency mixer included in the third frequency mixing module in the third frequency mixing unit is configured to perform frequency mixing processing on the first local-oscillator signal and one first phase-shifted signal of the N first phase-shifted signals obtained by the third phase shifting unit, and the sixth frequency mixer included in the third frequency mixing module in the third frequency mixing unit is configured to perform frequency mixing processing on the first local-oscillator signal and one second phase-shifted signal of the N second phase-shifted signals obtained by the third phase shifting unit. The fifth frequency mixer and the sixth frequency mixer may be two frequency mixers independent of each other, or may be two frequency mixing components in one IQ frequency mixer. One radio frequency signal of any waveform may be output by using the fifth frequency mixer and the sixth frequency mixer that are included in the third frequency mixing module. The N frequency mixing modules in the third frequency mixing unit include the third frequency mixing module, so that phases or frequencies of N output radio frequency signals of any waveforms are different from each other. In addition, there is no feedback adjustment of an analog device in a generation process, so that good linearity and short settling time can be implemented, thereby solving problems of poor linearity and long settling time in a current analog modulated radar.

In a possible implementation, the frequency mixing and phase shifting unit includes:
a fourth frequency mixing unit and a fifth frequency mixing unit;
the fourth frequency mixing unit is configured to: separately perform frequency mixing processing on each second local-oscillator signal of N second local-oscillator signals, a quadrature signal corresponding to each second local-oscillator signal, and N baseband sub-signals corresponding to the first baseband signal, to obtain N first frequency-mixed signals; and is configured to: separately perform frequency mixing processing on each second local-oscillator signal of the N second local-oscillator signals, the quadrature signal corresponding to each second local-oscillator signal, and N baseband sub-signals corresponding to the second baseband signal, to obtain N second frequency-mixed signals; and
the fifth frequency mixing unit is configured to separately perform frequency mixing processing on the N first frequency-mixed signals and the N second frequency-mixed signals to obtain the N radio frequency signals.

In an implementation of this application, a possible specific implementation of the frequency mixing and phase shifting unit is provided. Specifically, the fourth frequency mixing unit in the frequency mixing and phase shifting unit is configured to separately perform frequency mixing processing on each second local-oscillator signal of the N second local-oscillator signals, the quadrature signal corresponding to each second local-oscillator signal, and the N baseband sub-signals corresponding to the first baseband signal to obtain the N first frequency-mixed signals; and separately perform frequency mixing processing on each second local-oscillator signal of the N second local-oscillator signals, the quadrature signal corresponding to each second local-oscillator signal, and the N baseband sub-signals corresponding to the second baseband signal to obtain the N second frequency-mixed signals. Phases of the N first frequency-mixed signals are different from each other, and phases of the N second frequency-mixed signals are different from each other. The fifth frequency mixing unit in the frequency mixing and phase shifting unit is configured to separately perform frequency mixing processing on the N first frequency-mixed signals and the N second frequency-mixed signals that are obtained by the fourth frequency mixing unit, which may be specifically separately performing frequency mixing processing on one first frequency-mixed signal of the N first frequency-mixed signals and one second frequency-mixed signal of the N second frequency-mixed signals to obtain N radio frequency signals, where phases or frequencies of the N radio frequency signals are different from each other. In the foregoing manner of first performing phase shifting and then frequency mixing processing, the generated N radio frequency signals may have any waveforms, and there is no feedback adjustment of an analog device in a generation process, so that good linearity and short settling time can be implemented.

In a possible implementation, frequencies of all second local-oscillator signals in the N second local-oscillator signals are different from each other.

In an implementation of this application, a possible specific implementation of the N second local-oscillator signals is provided. Specifically, the frequencies of all the second local-oscillator signals in the N second local-oscillator signals are different from each other, and the frequencies of the N second local-oscillator signals are also different from the frequency of the first local-oscillator signal. The N first frequency-mixed signals and the N second frequency-mixed signals are obtained by using the N second local-oscillator signals that have different frequencies, so that the phases of the N first frequency-mixed signals are different from each other, and the phases of the N second frequency-mixed signals are different from each other.

In a possible implementation, the fourth frequency mixing unit includes 2N frequency mixing modules, and a fourth frequency mixing module in the 2N frequency mixing modules includes:
a seventh frequency mixer and an eighth frequency mixer;
the seventh frequency mixer is configured to perform frequency mixing processing on one second local-oscillator signal of the N second local-oscillator signals and a first baseband sub-signal corresponding to the first baseband signal;
the eighth frequency mixer is configured to perform frequency mixing processing on a quadrature signal corresponding to the one second local-oscillator signal and the first baseband sub-signal corresponding to the first baseband signal;
a fifth frequency mixing module in the 2N frequency mixing modules includes:
   a ninth frequency mixer and a tenth frequency mixer;
   the ninth frequency mixer is configured to perform frequency mixing processing on one second local-oscillator signal of the N second local-oscillator signals and a second baseband sub-signal corresponding to the second baseband signal; and
   the tenth frequency mixer is configured to perform frequency mixing processing on a quadrature signal corresponding to the one second local-oscillator signal and the second baseband sub-signal corresponding to the second baseband signal.

In an implementation of this application, a possible specific implementation of the fourth frequency mixing unit is provided. Specifically, the seventh frequency mixer included in the fourth frequency mixing module in the fourth frequency mixing unit is configured to perform frequency mixing processing on one second local-oscillator signal of the N second local-oscillator signals and the first baseband sub-signal corresponding to the first baseband signal, and the eighth frequency mixer included in the fourth frequency mixing module in the fourth frequency mixing unit is configured to perform frequency mixing processing on the quadrature signal corresponding to the one second local-oscillator signal and the first baseband sub-signal corresponding to the first baseband signal. The seventh frequency mixer and the eighth frequency mixer may be two frequency mixers independent of each other, or may be two frequency mixing components in one IQ frequency mixer. The first baseband sub-signal may be one first baseband sub-signal of N corresponding first baseband sub-signals obtained after the first baseband signal undergoes power splitting. One first frequency-mixed signal may be output by using the seventh frequency mixer and the eighth frequency mixer that are included in the fourth frequency mixing module. The 2N frequency mixing modules in the fourth frequency mixing unit include the fourth frequency mixing module, so that N first frequency-mixed signals can be output, and phases of the N first frequency-mixed signals are different from each other.

Similarly, the ninth frequency mixer included in the fifth frequency mixing module in the fourth frequency mixing unit is configured to perform frequency mixing processing on one second local-oscillator signal of the N second local-oscillator signals and the second baseband sub-signal corresponding to the second baseband signal, and the tenth frequency mixer included in the fifth frequency mixing module in the fourth frequency mixing unit is configured to perform frequency mixing processing on the quadrature signal corresponding to the one second local-oscillator signal and the second baseband sub-signal corresponding to the second baseband signal. The ninth frequency mixer and the tenth frequency mixer may be two frequency mixers independent of each other, or may be two frequency mixing components in one IQ frequency mixer. The second baseband sub-signal may be one second baseband sub-signal of N second baseband sub-signals obtained after the second baseband signal undergoes power splitting. One second frequency-mixed signal may be output by using the ninth frequency mixer and the tenth frequency mixer that are included in the fifth frequency mixing module. The 2N frequency mixing modules in the fourth frequency mixing unit include the fifth frequency mixing module, so that N second frequency-mixed signals can be output, and phases of the N second frequency-mixed signals are different from each other.

In a possible implementation, the fifth frequency mixing unit includes N frequency mixing modules, and a sixth frequency mixing module in the N frequency mixing modules includes:
an eleventh frequency mixer and a twelfth frequency mixer;
the eleventh frequency mixer is configured to perform frequency mixing processing on a first local-oscillator signal and one first frequency-mixed signal of the N first frequency-mixed signals; and
the twelfth frequency mixer is configured to perform frequency mixing processing on the first local-oscillator signal and one second frequency-mixed signal of the N second frequency-mixed signals.

In an implementation of this application, a possible specific implementation of the fifth frequency mixing unit is provided. Specifically, the eleventh frequency mixer included in the sixth frequency mixing module in the fifth frequency mixing unit is configured to perform frequency mixing processing on the first local-oscillator signal and one first frequency-mixed signal of the N first frequency-mixed signals obtained by the fourth frequency mixing unit, and the twelfth frequency mixer included in the sixth frequency mixing module in the fifth frequency mixing unit is configured to perform frequency mixing processing on the first local-oscillator signal and one second frequency-mixed signal of the N second frequency-mixed signals obtained by the fourth frequency mixing unit. The eleventh frequency mixer and the twelfth frequency mixer may be two frequency mixers independent of each other, or may be two frequency mixing components in one IQ frequency mixer. One radio frequency signal of any waveform may be output by using the eleventh frequency mixer and the twelfth frequency mixer that are included in the sixth frequency mixing module. The N frequency mixing modules in the fifth frequency mixing unit include the sixth frequency mixing module, so that phases or frequencies of N output radio frequency signals of any waveforms are different from each other. In addition, there is no feedback adjustment of an analog device in a generation process, so that good linearity and short settling time can be implemented, thereby solving problems of poor linearity and long settling time in a current analog modulated radar.

In a possible implementation, the signal generation unit includes:
a first digital-to-analog converter and a second digital-to-analog converter;
the first digital-to-analog converter is configured to perform digital-to-analog conversion on an input first digital signal, to obtain the first baseband signal; and
the second digital-to-analog converter is configured to perform digital-to-analog conversion on an input second digital signal, to obtain the second baseband signal.

In an implementation of this application, a possible specific implementation of the signal generation unit is provided. Specifically, the first digital-to-analog converter in the signal generation unit is configured to perform digital-to-analog conversion on the input first digital signal, and the second digital-to-analog converter in the signal generation unit is configured to perform digital-to-analog conversion on the input second digital signal. The first digital-to-analog converter and the second digital-to-analog converter in the signal generation unit may be used to generate the first baseband signal and the second baseband signal that are orthogonal to each other.

In a possible implementation, the signal generation unit includes:
a first phase shifter and a second phase shifter;
the first phase shifter is configured to perform phase shifting processing on an input first digital signal and a third local-oscillator signal to obtain the first baseband signal; and
the second phase shifter is configured to perform phase shifting processing on an input second digital signal and the third local-oscillator signal to obtain the second baseband signal.

In an implementation of this application, a possible specific implementation of the signal generation unit is provided. Specifically, the first phase shifter in the signal generation unit is configured to perform phase shifting processing on the input first digital signal and the third local-oscillator signal, and the second phase shifter in the signal generation unit is configured to perform phase shifting processing on the input second digital signal and the third local-oscillator signal. A frequency of the third local-oscillator signal is different from a frequency of the first local-oscillator signal and a frequency of the second local-oscillator signal. The first phase shifter and the second phase shifter in the signal generation unit may be used to generate the first baseband signal and the second baseband signal that are orthogonal to each other.

According to a second aspect, an embodiment of this application provides a chip, where the chip includes the signal processing system according to the first aspect or any possible implementation of the first aspect.

According to a third aspect, an embodiment of this application provides a radar or a radar system, where the radar or the radar system includes the signal processing system according to the first aspect or any possible implementation of the first aspect, or includes the chip according to the second aspect. It should be noted that there may be a smart sensor integrated with a plurality of sensors. When the smart sensor includes a millimeter-wave detection function, the smart sensor may also be referred to as a millimeter-wave radar system or a millimeter-wave radar system.

According to a fourth aspect, an embodiment of this application provides a terminal device, where the terminal device includes the signal processing system according to the first aspect or any possible implementation of the first aspect, or includes the chip according to the second aspect, or includes the radar or the radar system according to the third aspect.

According to a fifth aspect, an embodiment of this application provides a vehicle, where the vehicle includes the signal processing system according to the first aspect or any possible implementation of the first aspect, or includes the chip according to the second aspect, or includes the radar or the radar system according to the third aspect, or includes the terminal device according to the fourth aspect.

In embodiments of this application, a signal generation unit is used to generate one baseband signal including two mutually quadrature signals, and a frequency mixing and phase shifting unit is used to perform frequency mixing processing and phase shifting processing on the one baseband signal, to obtain N radio frequency signals whose phases or frequencies are different from each other. The N radio frequency signals may have any waveforms, and there is no feedback adjustment of an analog device in a generation process, so that good linearity and short settling time can be implemented, thereby solving problems that a current analog modulated radar has poor linearity and long settling time.

### BRIEF DESCRIPTION OF DRAWINGS

To describe the technical solutions in embodiments of this application more clearly, the following briefly describes the accompanying drawings used in embodiments of this application. It is clear that, the accompanying drawings described below show merely some embodiments of this application, and a person of ordinary skill in the art may still derive other drawings from these accompanying drawings without creative efforts.
FIG. 1 is a diagram of radar distribution according to an embodiment of this application;
FIG. 2 is a diagram of an architecture of a radar according to an embodiment of this application;
FIG. 3 is a diagram of an architecture of a radar according to an embodiment of this application;
FIG. 4 is a diagram of a structure of a signal processing system according to an embodiment of this application;
FIG. 5 is a diagram of a structure of a signal processing system according to an embodiment of this application;
FIG. 6 is a diagram of a structure of a signal processing system according to an embodiment of this application;
FIG. 7 is a diagram of a structure of another signal processing system according to an embodiment of this application;
FIG. 8 is a diagram of a structure of still another signal processing system according to an embodiment of this application;
FIG. 9 is a diagram of a structure of still another signal processing system according to an embodiment of this application;
FIG. 10 is a diagram of a structure of still another signal processing system according to an embodiment of this application;
FIG. 11 is a diagram of a structure of still another signal processing system according to an embodiment of this application;
FIG. 12 is a diagram of a structure of still another signal processing system according to an embodiment of this application;
FIG. 13 is a diagram of a structure of still another signal processing system according to an embodiment of this application;
FIG. 14 is a diagram of a structure of still another signal processing system according to an embodiment of this application;
FIG. 15 is a diagram of a structure of still another signal processing system according to an embodiment of this application;
FIG. 16 is a diagram of a structure of still another signal processing system according to an embodiment of this application;
FIG. 17 is a diagram of a structure of still another signal processing system according to an embodiment of this application;
FIG. 18 is a diagram of a structure of still another signal processing system according to an embodiment of this application;
FIG. 19 is a diagram of a signal according to an embodiment of this application;
FIG. 20 is a diagram of a signal according to an embodiment of this application; and
FIG. 21 is a diagram of a structure of still another signal processing system according to an embodiment of this application.

### DESCRIPTION OF EMBODIMENTS

To make objectives, technical solutions, and advantages of this application clearer, the following describes embodiments of this application with reference to accompanying drawings in embodiments of this application.

The terms "first", "second", and the like in the specification, claims, and accompanying drawings of this application are used to distinguish between different objects, but are not used to describe a specific sequence. In addition, terms such as "include" and "have" and any other variants thereof are intended to cover a non-exclusive inclusion. For example, processes, methods, systems, products, or devices that include a series of steps or units are not limited to listed steps or units, but instead, optionally further include steps or units that are not listed, or optionally further include other steps or units inherent to these processes, methods, products, or devices.

"Embodiments" mentioned herein mean that specific features, structures, or characteristics described in combination with the embodiments may be included in at least one embodiment of this application. The phrase shown in various locations in the specification may not necessarily refer to a same embodiment, and is not an independent or optional embodiment exclusive from another embodiment. It may be understood explicitly and implicitly by a person skilled in the art that the embodiments described herein may be combined with other embodiments.

It should be understood that, in this application, "at least one (item)" means one or more, "a plurality of" means two or more, "at least two (items)" means two, three, or more, and "and/or" is used to describe an association relationship between associated objects, and indicates that there may be three relationships. For example, "A and/or B" may indicate that only A exists, only B exists, and both A and B exist, where A and B may be singular or plural. The character "/" generally indicates an "or" relationship between the associated objects. "At least one of the following items (pieces)" or a similar expression thereof means any combination of these items, including any combination of singular items (pieces) or plural items (pieces). For example, at least one of a, b, or c may indicate a, b, c, a and b, a and c, b and c, or a, b, and c, where a, b, and c may be singular or plural.

As described in the background, it is necessary to study how to solve problems of poor linearity and long settling time of a current analog modulated radar. This application provides a signal processing system and a related apparatus, and relates to the field of millimeter-wave radar technologies, so as to effectively solve problems of poor linearity and long settling time.

To describe the solutions of this application more clearly, the following first describes some knowledge related to a radar.

The radar is a transliterated name of the Radar in English, and is short for "radio detection and ranging", that is, "radio detection and ranging". The radar is used to discover a target and determine a spatial position of the target by using a radio method.

A detection medium of the radar is an electromagnetic wave, and the radar implements detection of a target, for example, range measurement, speed measurement, or azimuth measurement, through transmission and reception of the electromagnetic wave. The radar can implement range detection on the target based on a time of flight of the electromagnetic wave. The time of flight is a time difference between receiving and transmitting of the electromagnetic wave. The radar transmits an electromagnetic wave signal, receives an echo signal of the electromagnetic wave signal, and may implement range detection on the target based on a time difference between the received echo signal and the transmitted electromagnetic wave signal and a propagation speed of the electromagnetic wave. A range between the radar and the target may be determined based on the following formula: s=c×t/2, where s is the range to the target, t is the time of flight, namely, a time period from transmitting of the electromagnetic wave signal from the radar to receiving of the echo signal, and c is the speed of light.

The radar implements speed measurement on the target based on a Doppler effect (Doppler effect). A principle of the Doppler effect is as follows: When a vibration source like a sound, light, and a radio wave moves relative to an observer at a relative speed, frequency of vibration received by the observer is different from frequency generated by the vibration source. When the electromagnetic wave transmitted by the radar moves relative to a detected object, frequency of the echo signal is different from frequency of the transmitted electromagnetic wave signal. When the target approaches an antenna of the radar, the frequency of the echo signal is higher than the frequency of the transmitted electromagnetic wave signal. When the target moves away from the antenna of the radar, the frequency of the echo signal is lower than the frequency of the transmitted electromagnetic wave signal. A frequency change caused by the Doppler effect is referred to as a Doppler frequency shift, which is proportional to the relative speed and inversely proportional to the vibration frequency. Therefore, by detecting a frequency difference between the transmitted electromagnetic wave signal and the echo signal, a moving speed of the target relative to the radar, namely, the relative speed of the target relative to the radar, can be measured.

The radar may measure an azimuth in an amplitude method, a phase method, or the like. The amplitude method is used to measure an angle by using an amplitude value of an echo signal received by an antenna, and a change rule of the amplitude value depends on an antenna directivity pattern and a scanning manner of the antenna. The phase method is used to measure an angle by using a phase difference between echo signals received by a plurality of antenna elements. For example, the radar receives echo signals reflected by a same target by using an antenna array, and calculates the azimuth of the target based on a phase difference of the echo signals.

A detection medium of a millimeter-wave radar is an electromagnetic wave within a specific wavelength range, for example, a microwave. Currently, a millimeter wave (millimeter wave) and a centimeter wave (for example, a centimeter wave in a 24 GHz frequency band) adjacent to the millimeter wave in wave bands are commonly used. The millimeter wave is an electromagnetic wave with a wavelength of 1 to 10 millimeters (mm), and a wavelength of an electromagnetic wave in the 24 GHz frequency band is slightly greater than 10 mm. A wavelength of the detection medium of the millimeter-wave radar is in an overlapped wavelength range of the microwave and a far infrared wave. Therefore, the detection medium of the millimeter-wave radar has characteristics of two spectrums. According to a wave propagation theory, higher frequency indicates a shorter the wavelength, higher resolution, and a stronger penetration capability, while in this case, a loss in a propagation process is larger, and a transmission distance is shorter. On the contrary, lower the frequency indicates a longer wavelength, a stronger diffraction capability, and a longer the transmission distance. Therefore, compared with the microwave, the detection medium of the millimeter-wave radar has high resolution, good directivity, a strong anti-interference capability, and good detection performance. Compared with infrared, the detection media of the millimeter-wave radar has lower atmospheric attenuation, better penetration to smoke and dust, and is less affected by weather. Therefore, the millimeter-wave radar is increasingly widely used in a plurality of fields such as intelligent vehicles, drones, intelligent transportation, and industrial automation.

Based on a detection range, the Radar can be classified into a long range radar (long range radar, LRR), a medium range radar (mid/medium range radar, MRR), and a short range radar (short range radar, SRR). The LRR has a high requirement on a detection range, and has a low requirement on a width of a detection angular domain. The SRR has a low requirement on a detection range, and has a high requirement on a width of a detection angular domain. A requirement of the MRR on a detection range and a width of an angular domain may be understood as being between that of the LRR and that of the SRR. For example, the detection range of the LRR may be more than 200 meters, and the width of the angular domain may be ±15°; the detection range of the MRR may be within 100 meters, and the width of the angular domain may be ±45°; and the detection range of the SRR may be within 60 meters, and the width of the angular domain may be ±80°. During use, different types of Radars may be installed at different positions of a vehicle body based on a function requirement of autonomous driving and a use status of another sensor. A quantity and types of the Radars may be selected based on a requirement.

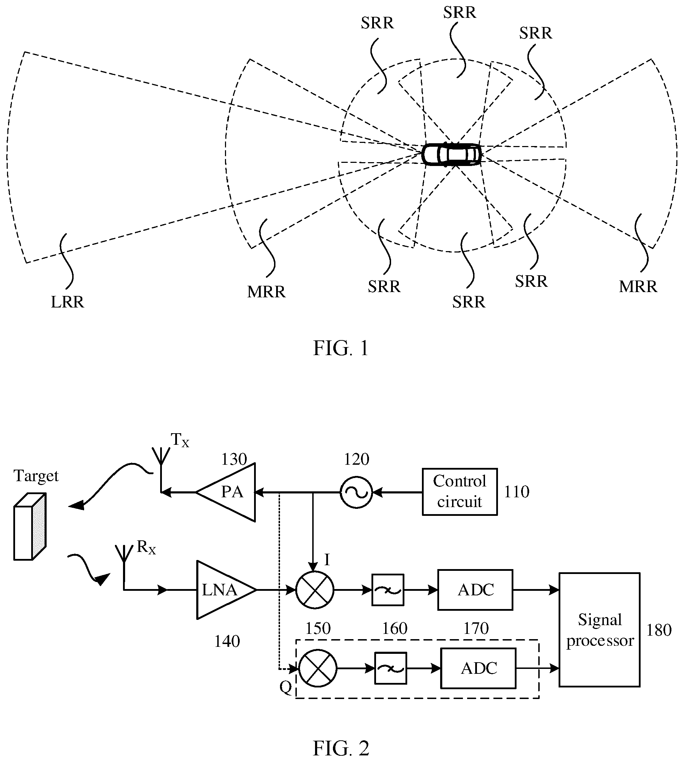

FIG. 1 is a diagram of radar distribution according to an embodiment of this application.

FIG. 1 shows possible installation positions of several types of Radars. The installation positions are merely examples, and during actual use, more or fewer Radars may be selected, and the types may also be adjusted.

As shown in FIG. 1, an LRR may be installed on the front of a vehicle body and serve as a forward radar; an MRR may be installed on the front or the rear of the vehicle body and serve as a forward radar or a backward radar; and an SRR may be installed on a side of the vehicle body or four corners of the vehicle body and serve as a side radar or an angular radar. In addition, the MRR may alternatively be installed on a side of the vehicle body or the four corners of the vehicle body, and the SRR may alternatively be installed on the front or rear of the vehicle body.

The Radar may be classified based on a modulation manner (or a radiation manner) of an electromagnetic wave of the Radar. The modulation manner of the electromagnetic wave of the Radar includes a pulse manner and a continuous wave manner. Therefore, the Radar may be classified into a pulse radar and a continuous wave radar. The continuous wave manner may be further classified into frequency shift keying (frequency shift keying, FSK), phase shift keying (phase shift keying, PSK), a constant-frequency/single-frequency continuous wave (continuous wave CW), a frequency modulated continuous wave (frequency modulated continuous wave, FMCW), multiple frequency shift keying (multiple frequency shift keying, MFSK), a phase modulated continuous wave (phase modulated continuous wave, PMCW), and another manner. Featuring in multi-target detection, high resolution, and low costs, the FMCW manner has become a mainstream radar modulation manner.

FIG. 2 is a diagram of an architecture of a radar according to an embodiment of this application.

As shown in FIG. 2, the Radar includes a control circuit 110, a signal generator 120, a power amplifier (power amplifier, PA) 130, a low noise amplifier (low noise amplifier, LNA) 140, a frequency mixer 150, a filter 160, an analog-to-digital converter (analog-to-digital converter, ADC) 170, and a signal processor 180. The signal processor, for example, a digital signal processor (digital signal processor, DSP), is usually configured to process a digital signal. The signal generator 120 generates an electromagnetic wave signal (also referred to as a radar signal) waveform under control of the control circuit 110. For example, a Radar using an FMCW modulation manner generates a sawtooth wave or a triangular wave under control of the control circuit 110. The signal generator 120 is, for example, a voltage-controlled oscillator, and the control circuit 110 is configured to generate a control voltage. The generated electromagnetic wave signal waveform is processed through conversion and modulation to a required frequency band, for example, between 76 GHz and 77 GHz, and is radiated to space through a transmit antenna (TX) after being amplified by the PA 130.

An electromagnetic wave signal radiated through the transmit antenna is radiated to a target and then reflected to the space, and is received by a receive antenna (RX) of the Radar. After being amplified by the LNA 140, the electromagnetic wave signal is mixed with a reference signal by the frequency mixer 150. The reference signal may generally use the foregoing generated electromagnetic wave signal. After filtering by the filter 160, the frequency mixer 150 may obtain an analog baseband signal, and obtain a digital baseband signal through sampling by the ADC 170. Signal processing of the digital baseband signal is completed in the signal processor 180, to obtain information about a range, a speed, and an angle of the target. In addition, processing such as clustering and/or tracking may be performed by using the obtained information, to further obtain information such as a track, a size, and a type of the target.

To reduce costs, a vehicle-mounted radar uses analog frequency mixing and analog filtering. With development of technologies, digital frequency mixing and digital filtering technologies and the like may be used. In a frequency mixing part, an I/Q quadrature frequency mixing technology may be used to obtain a complex baseband signal (an I signal and a Q signal), that is, the frequency mixer, the filter, and the ADC in the dashed box in the figure are included; or I single-channel frequency mixing may be used to obtain a single baseband signal, that is, the frequency mixer, the filter, and the ADC in the dashed box in the figure are not included.

The foregoing components of the Radar may be integrated based on a requirement to implement miniaturization of the radar. For example, components such as the control circuit 110, the signal generator 120, the power amplifier (power amplifier, PA) 130, the low noise amplifier (low noise amplifier, LNA) 140, the frequency mixer 150, the filter 160, and the analog-to-digital converter (analog-to-digital converter, ADC) 170 may be integrated on at least one chip, for example, integrated into a monolithic microwave integrated circuit (monolithic microwave integrated circuit, MMIC).

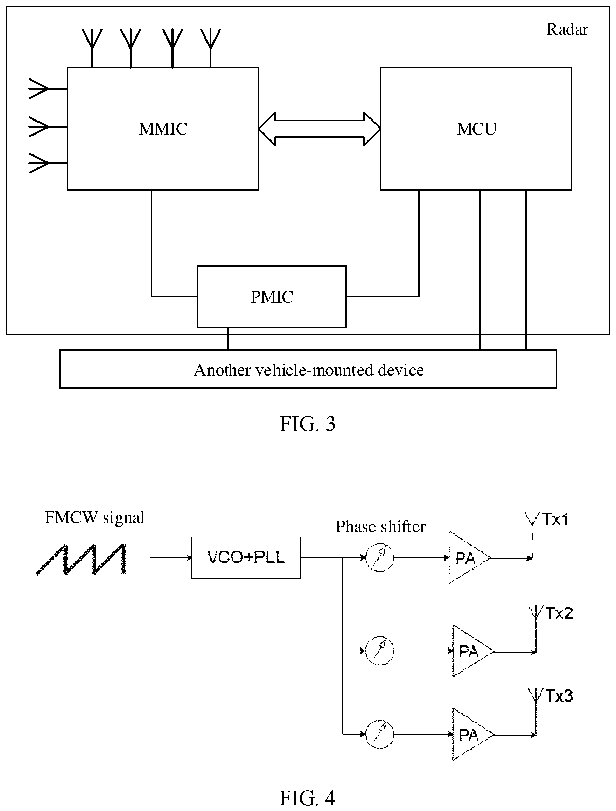

Specifically, refer to FIG. 3. FIG. 3 is a diagram of an architecture of a radar according to an embodiment of this application.

As shown in FIG. 3, the Radar includes an MMIC, a microcontroller unit (microcontroller unit, MCU), and a power management integrated circuit (power management integrated circuit, PMIC). The MMIC may integrate a function of a radio frequency part. The MCU may integrate a function of the foregoing baseband part, for example, integrate a function of the foregoing signal processor. In addition, the MCU may further provide a communication interface for communicating with another vehicle-mounted device. The PMIC is a chip that supplies power to a hardware system of the radar.

In addition, a multiple-input multiple-output (multiple-input multiple-output, MIMO) technology can provide better angle resolution performance for the radar, and is widely used in the field of autonomous driving.

For example, the radar using the MIMO technology may be applied to an autonomous driving vehicle, and a plurality of antennas included in the radar may be disposed at a plurality of locations of a vehicle body, to implement perception of an environment around the vehicle. In this case, the MIMO radar may scan multiple targets at the same time when transmitting signals in a Doppler-frequency division multiplexing (Doppler-frequency division multiplexing, DDM) manner. The radar may obtain a Doppler spectrum based on a transmitted signal and a received echo signal, and then determine a detected target based on the Doppler spectrum, and perform target measurement, for example, measurement of a range and a speed.

On a range velocity (Range velocity, RV) spectrum of a signal transmitted in a DDM manner after being processed by a receive end, there are multiple peak values at a same range unit but different speed units, and a quantity of peak values is related to a quantity of transmit antennas. As the quantity of radar transmit antennas increases, there will be more spectrum peaks in a Doppler spectrum.

Therefore, a frequency bandwidth of the Doppler spectrum needs to be increased to ensure a proper frequency difference between DDM spectrum peaks.

Optionally, for a signal processing system using the MIMO technology, refer to FIG. 4. FIG. 4 is a diagram of a structure of a signal processing system according to an embodiment of this application.

As shown in FIG. 4, a transmit end thereof implements a linear change of a frequency of a sent signal by using a voltage-controlled oscillator (voltage-controlled oscillator, VCO) and a phase-locked loop (phase-locked loop, PLL). The voltage-controlled oscillator may output, under voltage control, a signal whose frequency changes linearly with time. Because the frequency of the signal output by the voltage-controlled oscillator is unstable, an FMCW signal with a stable frequency and high precision may be obtained through negative feedback processing in the phase-locked loop. When the signal processing system has multiple transmit antennas (for example, transmit antennas Tx1, Tx2, and Tx3), to implement the MIMO technology, signals transmitted by the multiple transmit antennas need to be orthogonal. Therefore, multiple phase shifters are added after the VCO+PLL module. Each transmit channel generates different transmit signals through time-varying phase shifting, and finally the signals are radiated by using the transmit antennas. A typical waveform for implementing MIMO transmission through phase shifting is the foregoing DDM manner. In the DDM manner, a frequency deviation between different transmit signals is implemented by changing a phase variation amount of each transmit channel in a unit time, so as to implement signal differentiation on a Doppler spectrum.

However, due to the introduction of negative feedback control, a period of oscillation is required after a sudden frequency change, to achieve good linearity. Therefore, each time a signal is output, a valid linear segment for wave transmission can be obtained only after a period of time, which increases a time for entering a valid pulse signal in a transmission period. Therefore, an FMCW signal with a small pulse repetition interval (pulse repetition interval, PRI) cannot be generated.

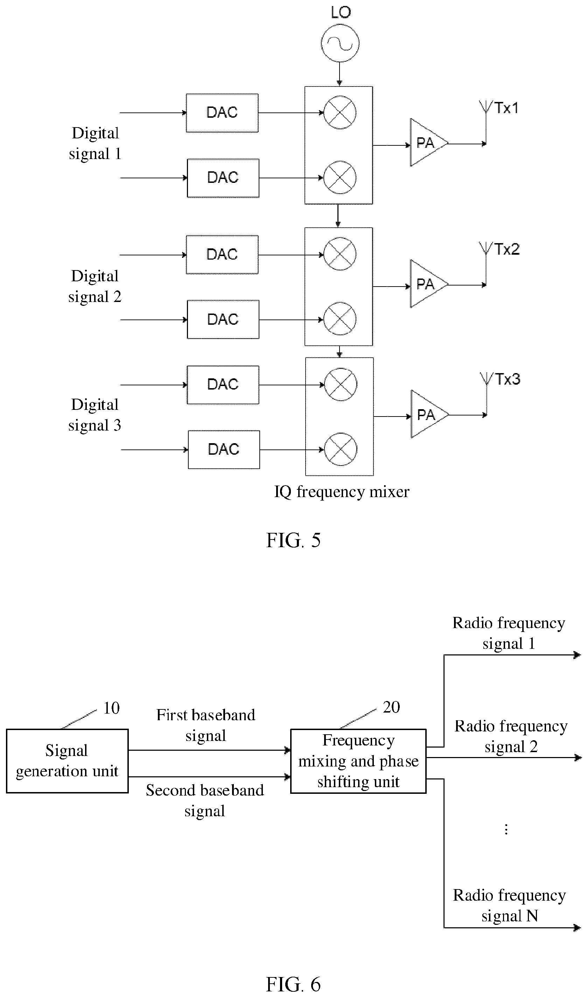

Optionally, for a signal processing system using the MIMO technology, further refer to FIG. 5. FIG. 5 is a diagram of a structure of a signal processing system according to an embodiment of this application.

As shown in FIG. 5, the signal processing system includes multiple groups of digital-to-analog converters (digital-to-analog converter, DAC). A biggest advantage of a DAC architecture is that any waveform such as an FMCW, a PMCW, and orthogonal frequency division multiplexing (orthogonal frequency division multiplexing, OFDM) can be generated. In this architecture, a time domain amplitude of a transmit waveform is stored in a storage unit. The DAC generates an analog low-frequency baseband signal, frequency mixing is performed on the baseband signal by using an IQ frequency mixer and a local oscillator (local oscillator, LO) to a generate a radio frequency signal, and the radio frequency signal passes through a power amplifier (power amplifier, PA) and is radiated through an antenna. In this architecture, in addition to a capability to generate any waveform, when the FMCW waveform is generated, there is no feedback adjustment process of an analog device. Therefore, there is no time constraint of a nonlinear segment, and a PRI can be shorter. Therefore, this architecture is more applicable to a multi-transmit-channel radar system.

However, when there are multiple transmit channels (for example, transmit antennas Tx1, Tx2, and Tx3) in a signal processing system, to transmit different signals on the multiple transmit channels, each channel has an independent DAC group. This inevitably causes an increase in hardware complexity, power consumption, and costs.

For technical problems of poor linearity, long settling time, high costs, and the like in the signal processing systems shown in FIG. 4 and FIG. 5, this application provides a new signal processing system and a related apparatus, and relates to the field of millimeter-wave radar technologies, to effectively solve the problems of poor linearity and long settling time in the signal processing system, and reduce costs.

The following describes a signal processing system provided in this application with reference to the accompanying drawings.

FIG. 6 is a diagram of a structure of a signal processing system according to an embodiment of this application.

As shown in FIG. 6, the signal processing system includes a signal generation unit 10, a frequency mixing and phase shifting unit 20, and N transmit ports (for example, Tx1, Tx2, ..., and TxN). N is a positive integer.

Functions of the signal generation unit 10, the frequency mixing and phase shifting unit 20, and the N transmit ports (Tx1, Tx2, ..., and TxN) are as follows:

The signal generation unit 10 is configured to generate one baseband signal, and the one baseband signal includes a first baseband signal and a second baseband signal that are orthogonal to each other.

The frequency mixing and phase shifting unit 20 is configured to process the one baseband signal, that is, perform frequency mixing processing and phase shifting processing on the first baseband signal and the second baseband signal, to obtain N radio frequency signals (a radio frequency signal 1, a radio frequency signal 2, ..., and a radio frequency signal N). It may be understood that, the frequency mixing and phase shifting unit 20 herein may perform frequency mixing processing and phase shifting processing on the first baseband signal and the second baseband signal for one or more times, and may perform frequency mixing processing before phase shifting processing, or may perform phase shifting processing before frequency mixing processing, or the like. This is not limited in this application.

The N transmit ports (Tx1, Tx2, ..., and TxN) are configured to transmit the N radio frequency signals (the radio frequency signal 1, the radio frequency signal 2, ..., and the radio frequency signal N) obtained by the frequency mixing and phase shifting unit 20, so that the N radio frequency signals can be respectively transmitted from the N transmit ports. For example, the transmit port Tx1 is configured to transmit the radio frequency signal 1, the transmit port Tx2 is configured to transmit the radio frequency signal 2, and the transmit port TxN is configured to transmit the radio frequency signal N. This is not limited in this application. Phases or frequencies of the N radio frequency signals are different from each other. In other words, phases or frequencies of the radio frequency signal 1, the radio frequency signal 2, ..., and the radio frequency signal N are different from each other. Further, the phases or the frequencies of the N radio frequency signals may change linearly, and have good linearity. The N transmit ports may be N transmit antennas.

The N radio frequency signals generated through the foregoing signal processing may have any waveforms, for example, an FMCW waveform, a PMCW waveform, or an OFDM waveform. In addition, compared with the signal processing system shown in FIG. 4, in a process of generating the N radio frequency signals in the signal processing system, there is no feedback adjustment of an analog device such as a phase-locked loop, and good linearity and short settling time can be implemented, thereby solving problems that a current analog modulated radar has poor linearity and long settling time. In addition, compared with the signal processing system shown in FIG. 5, in this signal processing system, to transmit different signals through multiple transmit channels, an independent DAC group does not need to be disposed on each channel, thereby reducing hardware complexity, reducing power consumption, and reducing costs.

In some possible embodiments, the N radio frequency signals (the radio frequency signal 1, the radio frequency signal 2, ..., and the radio frequency signal N) generated by the frequency mixing and phase shifting unit 20 in the signal processing system may be FMCWs, or may be PMCWs. The N radio frequency signals meet any PRI, and a radio frequency signal of any waveform can be implemented, thereby solving a problem that a radio frequency signal with a small PRI cannot be generated due to poor linearity in a current analog modulated radar.

In some possible embodiments, the first baseband signal is an in-phase (in-phase) signal, and the second baseband signal is a quadrature (quadrature) signal. A phase difference between the in-phase signal and the quadrature signal is 90 degrees. The two signals are combined into one output signal by using an adder, that is, a quadrature modulation signal. It may be understood that, the first baseband signal and the second baseband signal included in the one baseband signal generated by the signal generation unit 10 are mutually quadrature signals.

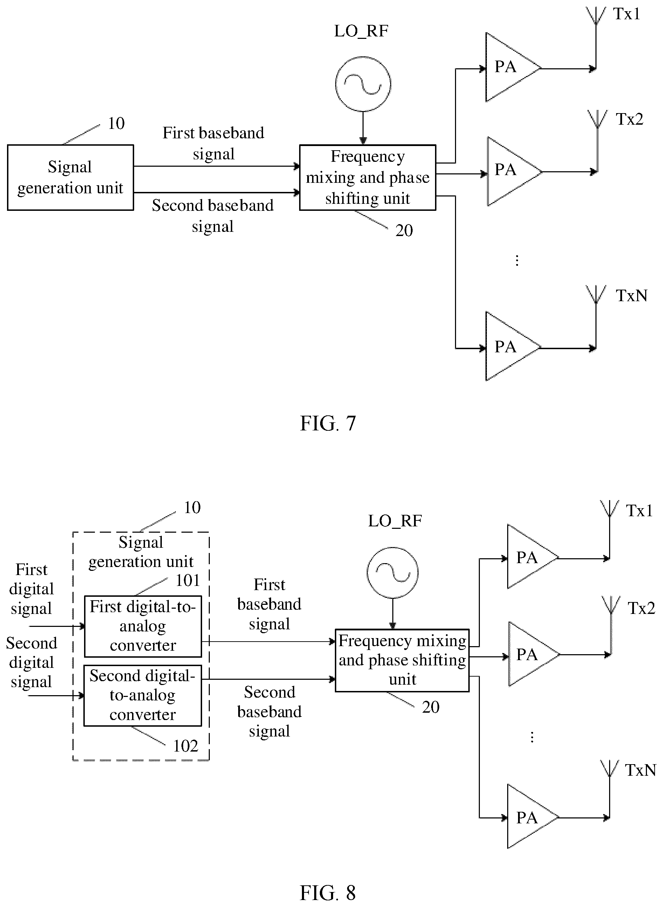

FIG. 7 is a diagram of a structure of a signal processing system according to an embodiment of this application. It may be understood that the signal processing system shown in FIG. 7 may be implemented as an independent embodiment, or the signal processing system shown in FIG. 7 may be understood as a variant of or a supplement to the signal processing system in FIG. 6.

As shown in FIG. 7, the signal processing system includes a signal generation unit 10, a frequency mixing and phase shifting unit 20, and N transmit ports (for example, Tx1, Tx2, ..., and TxN). N is a positive integer.

Specifically, for connection relationships and function descriptions of the signal generation unit 10, the frequency mixing and phase shifting unit 20, and the N transmit ports (for example, Tx1, Tx2, ..., and TxN), refer to FIG. 6. Details are not described herein again.

Optionally, in this signal processing system, to better implement transmission of different signals on multiple transmit channels, a power amplifier (power amplifier, PA) is disposed on each channel, so that all generated N radio frequency signals can pass through the power amplifier and be radiated from an antenna, thereby improving a radio frequency signal detection capability.

Optionally, the frequency mixing and phase shifting unit 20 in the signal processing system is configured to separately perform frequency mixing processing and phase shifting processing on the first baseband signal, a second baseband signal, and a first local-oscillator signal (LO_RF), to obtain N radio frequency signals (a radio frequency signal 1, a radio frequency signal 2, ..., and a radio frequency signal N). It may be understood that the frequency mixing and phase shifting unit 20 herein may perform frequency mixing processing and phase shifting processing on the first baseband signal, the second baseband signal, and the first local-oscillator signal (LO_RF) for one or more times, and may perform frequency mixing processing before phase shifting processing, or may perform phase shifting processing before frequency mixing processing, or the like. This is not limited in this application.

The N radio frequency signals generated through the foregoing signal processing may have any waveforms. In addition, compared with the signal processing system shown in FIG. 4, in a process of generating the N radio frequency signals in the signal processing system, there is no feedback adjustment of an analog device such as a phase-locked loop, and good linearity and short settling time can be implemented, thereby solving problems that a current analog modulated radar has poor linearity and long settling time. In addition, compared with the signal processing system shown in FIG. 5, in this signal processing system, to transmit different signals through multiple transmit channels, an independent DAC group does not need to be disposed on each channel, thereby reducing hardware complexity, reducing power consumption, and reducing costs.

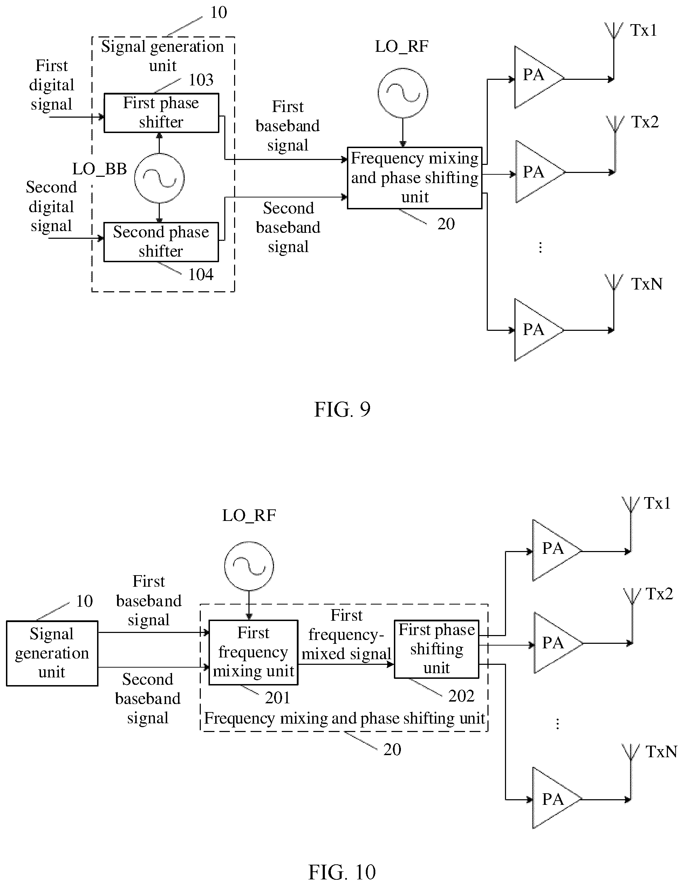

FIG. 8 and FIG. 9 are diagrams of structures of two signal processing systems according to an embodiment of this application. It may be understood that the signal processing systems shown in FIG. 8 and FIG. 9 may be implemented as independent embodiments, or the signal processing systems shown in FIG. 8 and FIG. 9 may be understood as variants of or supplements to the signal processing system in FIG. 6 or FIG. 7.

As shown in FIG. 8 and FIG. 9, the signal processing systems each include a signal generation unit 10, a frequency mixing and phase shifting unit 20, and N transmit ports (for example, Tx1, Tx2, ..., and TxN). N is a positive integer.

The signal generation unit 10 is configured to generate one baseband signal, and the one baseband signal includes a first baseband signal and a second baseband signal that are orthogonal to each other.

Optionally, the signal generation unit 10 may be implemented in a plurality of implementations. The following provides two possible implementations:

### Implementation 1:

In a possible embodiment, the signal generation unit 10 includes a first digital-to-analog converter 101 and a second digital-to-analog converter 102. For details, refer to FIG. 8.

The first digital-to-analog converter 101 is configured to perform digital-to-analog conversion on an input first digital signal to obtain a first baseband signal. The second digital-to-analog converter 102 is configured to perform digital-to-analog conversion on an input second digital signal to obtain a second baseband signal. The first digital-to-analog converter and the second digital-to-analog converter in the signal generation unit may be used to generate the first baseband signal and the second baseband signal that are orthogonal to each other.

### Implementation 2:

In another possible embodiment, the signal generation unit 10 includes a first phase shifter 103 and a second phase shifter 104. For details, refer to FIG. 9.

The first phase shifter 103 is configured to perform phase shifting processing on an input first digital signal and a third local-oscillator signal (LO_BB) to obtain a first baseband signal. The second phase shifter 104 is configured to perform phase shifting processing on an input second digital signal and the third local-oscillator signal (LO_BB) to obtain a second baseband signal. A frequency of the third local-oscillator signal (LO_BB) is different from a frequency of the first local-oscillator signal (LO_RF). The first phase shifter and the second phase shifter in the signal generation unit may be used to generate the first baseband signal and the second baseband signal that are orthogonal to each other.

It may be understood that Implementation 1 and Implementation 2 are merely used as two possible implementations of the signal generation unit 10 for description, and should not constitute a limitation on embodiments of this application. Proper variants of or supplements to Implementation 1 and Implementation 2 should be used as possible implementations of the signal generation unit 10 provided in this application for protection.

In addition, functions of the frequency mixing and phase shifting unit 20 and the N transmit ports (Tx1, Tx2, ..., and TxN) shown in FIG. 8 and FIG. 9 are as follows:
The frequency mixing and phase shifting unit 20 is configured to process the one baseband signal, that is, perform frequency mixing processing and phase shifting processing on the first baseband signal and the second baseband signal, to obtain N radio frequency signals (a radio frequency signal 1, a radio frequency signal 2, ..., and a radio frequency signal N). It may be understood that, the frequency mixing and phase shifting unit 20 herein may perform frequency mixing processing and phase shifting processing on the first baseband signal and the second baseband signal for one or more times, and may perform frequency mixing processing before phase shifting processing, or may perform phase shifting processing before frequency mixing processing, or the like. This is not limited in this application.

The N transmit ports (Tx1, Tx2, ..., and TxN) are configured to transmit the N radio frequency signals (the radio frequency signal 1, the radio frequency signal 2, ..., and the radio frequency signal N) obtained by the frequency mixing and phase shifting unit 20, so that the N radio frequency signals can be respectively transmitted from the N transmit ports. For example, the transmit port Tx1 is configured to transmit the radio frequency signal 1, the transmit port Tx2 is configured to transmit the radio frequency signal 2, and the transmit port TxN is configured to transmit the radio frequency signal N. This is not limited in this application. Phases or frequencies of the N radio frequency signals are different from each other. In other words, phases or frequencies of the radio frequency signal 1, the radio frequency signal 2, ..., and the radio frequency signal N are different from each other.

The N radio frequency signals generated through the foregoing signal processing may have any waveforms. In addition, compared with the signal processing system shown in FIG. 4, in a process of generating the N radio frequency signals in the signal processing system, there is no feedback adjustment of an analog device such as a phase-locked loop, and good linearity and short settling time can be implemented, thereby solving problems that a current analog modulated radar has poor linearity and long settling time. In addition, compared with the signal processing system shown in FIG. 5, in this signal processing system, to transmit different signals through multiple transmit channels, an independent DAC group does not need to be disposed on each channel, thereby reducing hardware complexity, reducing power consumption, and reducing costs.

FIG. 10 is a diagram of a structure of a signal processing system according to an embodiment of this application.

It may be understood that the signal processing system shown in FIG. 10 may be implemented as an independent embodiment, or the signal processing system shown in FIG. 10 may be understood as a variant of or a supplement to the signal processing systems in FIG. 6 to FIG. 9.

As shown in FIG. 10, the signal processing system includes a signal generation unit 10, a frequency mixing and phase shifting unit 20, and N transmit ports (for example, Tx1, Tx2, ..., and TxN). N is a positive integer.

The signal generation unit 10 is configured to generate one baseband signal, and the one baseband signal includes a first baseband signal and a second baseband signal that are orthogonal to each other.

Optionally, the signal generation unit 10 may be implemented in a plurality of implementations, as shown by the signal generation unit in the signal processing system shown in FIG. 8 or FIG. 9. Details are not described herein again.

It may be understood that the signal generation unit in the signal processing system shown in FIG. 8 or FIG. 9 is merely used as two possible implementations of the signal generation unit 10 for description, and should not constitute a limitation on embodiments of this application. A proper variant of or supplement to the signal generation unit in the signal processing system shown in FIG. 8 or FIG. 9 should be used as a possible implementation of the signal generation unit 10 provided in this application for protection.

In addition, functions of the frequency mixing and phase shifting unit 20 and the N transmit ports (Tx1, Tx2, ..., and TxN) shown in FIG. 10 are as follows:
The frequency mixing and phase shifting unit 20 is configured to process the one baseband signal, that is, perform frequency mixing processing and phase shifting processing on the first baseband signal and the second baseband signal, to obtain N radio frequency signals (a radio frequency signal 1, a radio frequency signal 2, ..., and a radio frequency signal N). It may be understood that, the frequency mixing and phase shifting unit 20 herein may perform frequency mixing processing and phase shifting processing on the first baseband signal and the second baseband signal for one or more times, and may perform frequency mixing processing before phase shifting processing, or may perform phase shifting processing before frequency mixing processing, or the like. This is not limited in this application.

Specifically, the frequency mixing and phase shifting unit 20 includes a first frequency mixing unit 201 and a first phase shifting unit 202.

Functions of the first frequency mixing unit 201 and the first phase shifting unit 202 are as follows:
The first frequency mixing unit 201 is configured to perform frequency mixing processing on the one baseband signal generated by the signal generation unit 10, which may be specifically performing frequency mixing processing on the first baseband signal and the first local-oscillator signal (LO_RF), to obtain a first frequency-mixed signal.

The first phase shifting unit 202 is configured to perform phase shifting processing on the first frequency-mixed signal to obtain the N radio frequency signals. Phases or frequencies of the N radio frequency signals are different from each other.

In the foregoing manner of first performing frequency mixing processing and then phase shifting processing, the generated N radio frequency signals may have any waveforms, and there is no feedback adjustment of an analog device in a generation process, so that good linearity and short settling time can be implemented.

The N transmit ports (Tx1, Tx2, ..., and TxN) are configured to transmit the N radio frequency signals (the radio frequency signal 1, the radio frequency signal 2, ..., and the radio frequency signal N) obtained by the frequency mixing and phase shifting unit 20, so that the N radio frequency signals can be respectively transmitted from the N transmit ports. For example, the transmit port Tx1 is configured to transmit the radio frequency signal 1, the transmit port Tx2 is configured to transmit the radio frequency signal 2, and the transmit port TxN is configured to transmit the radio frequency signal N. This is not limited in this application. Phases or frequencies of the N radio frequency signals are different from each other. In other words, phases or frequencies of the radio frequency signal 1, the radio frequency signal 2, ..., and the radio frequency signal N are different from each other.

The N radio frequency signals generated through the foregoing signal processing may have any waveforms. In addition, compared with the signal processing system shown in FIG. 4, in a process of generating the N radio frequency signals in the signal processing system, there is no feedback adjustment of an analog device such as a phase-locked loop, and good linearity and short settling time can be implemented, thereby solving problems that a current analog modulated radar has poor linearity and long settling time. In addition, compared with the signal processing system shown in FIG. 5, in this signal processing system, to transmit different signals through multiple transmit channels, an independent DAC group does not need to be disposed on each channel, thereby reducing hardware complexity, reducing power consumption, and reducing costs.

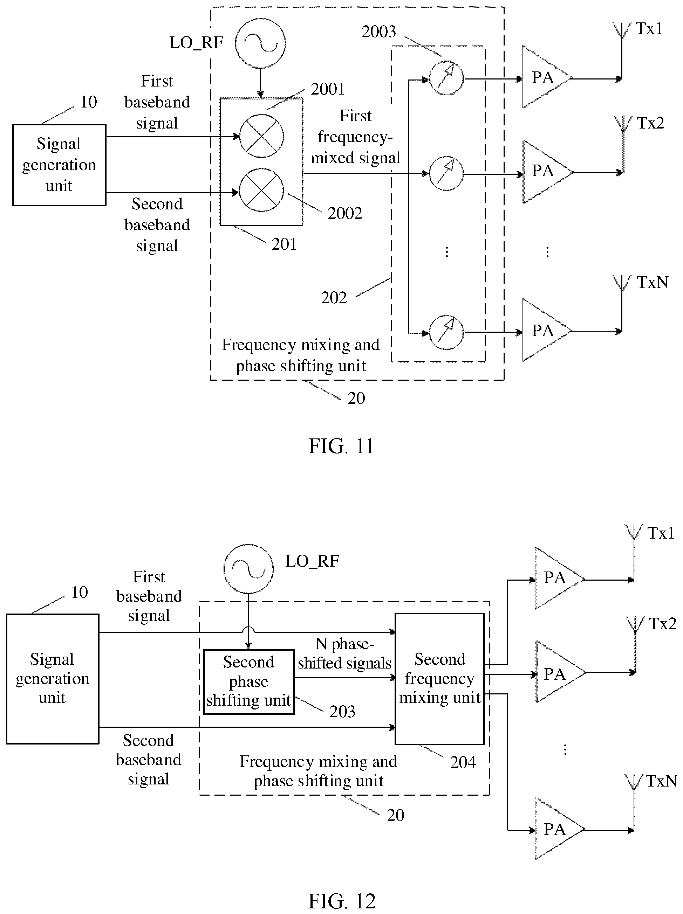

FIG. 11 is a diagram of a structure of a signal processing system according to an embodiment of this application.

It may be understood that the signal processing system shown in FIG. 11 may be implemented as an independent embodiment, or the signal processing system shown in FIG. 11 may be understood as a variant of or a supplement to the signal processing system in FIG. 10.

As shown in FIG. 11, the signal processing system includes a signal generation unit 10, a frequency mixing and phase shifting unit 20, and N transmit ports (for example, Tx1, Tx2, ..., and TxN). N is a positive integer.

The signal generation unit 10 is configured to generate one baseband signal, and the one baseband signal includes a first baseband signal and a second baseband signal that are orthogonal to each other.

Optionally, the signal generation unit 10 may be implemented in a plurality of implementations, as shown by the signal generation unit in the signal processing system shown in FIG. 8 or FIG. 9. Details are not described herein again.

It may be understood that the signal generation unit in the signal processing system shown in FIG. 8 or FIG. 9 is merely used as two possible implementations of the signal generation unit 10 for description, and should not constitute a limitation on embodiments of this application. A proper variant of or supplement to the signal generation unit in the signal processing system shown in FIG. 8 or FIG. 9 should be used as a possible implementation of the signal generation unit 10 provided in this application for protection.

In addition, functions of the frequency mixing and phase shifting unit 20 and the N transmit ports (Tx1, Tx2, ..., and TxN) shown in FIG. 11 are as follows:
The frequency mixing and phase shifting unit 20 is configured to process the one baseband signal, that is, perform frequency mixing processing and phase shifting processing on the first baseband signal and the second baseband signal, to obtain N radio frequency signals (a radio frequency signal 1, a radio frequency signal 2, ..., and a radio frequency signal N). It may be understood that, the frequency mixing and phase shifting unit 20 herein may perform frequency mixing processing and phase shifting processing on the first baseband signal and the second baseband signal for one or more times, and may perform frequency mixing processing before phase shifting processing, or may perform phase shifting processing before frequency mixing processing, or the like. This is not limited in this application.

Specifically, the frequency mixing and phase shifting unit 20 includes a first frequency mixing unit 201 and a first phase shifting unit 202.

Functions of the first frequency mixing unit 201 and the first phase shifting unit 202 are as follows:
The first frequency mixing unit 201 is configured to perform frequency mixing processing on the one baseband signal generated by the signal generation unit 10, which may be specifically performing frequency mixing processing on the first baseband signal and the first local-oscillator signal (LO_RF), to obtain a first frequency-mixed signal.

The first phase shifting unit 202 is configured to perform phase shifting processing on the first frequency-mixed signal to obtain the N radio frequency signals. Phases or frequencies of the N radio frequency signals are different from each other.

In the foregoing manner of first performing frequency mixing processing and then phase shifting processing, the generated N radio frequency signals may have any waveforms, and there is no feedback adjustment of an analog device in a generation process, so that good linearity and short settling time can be implemented.

Further, the first frequency mixing unit 201 includes a first frequency mixing module, and the first frequency mixing module includes a first frequency mixer 2001 and a second frequency mixer 2002.

Functions of the first frequency mixer 2001 and the second frequency mixer 2002 are as follows:
The first frequency mixer 2001 is configured to perform frequency mixing processing on the first baseband signal and a first local-oscillator signal (LO_RF).

The second frequency mixer 2002 is configured to perform frequency mixing processing on the second baseband signal and the first local-oscillator signal (LO_RF).

It may be understood that the first frequency mixer 2001 and the second frequency mixer 2002 in this embodiment of this application may be two frequency mixers independent of each other, or may be two frequency mixing components in one IQ frequency mixer.

The first frequency mixer and the second frequency mixer included in the first frequency mixing module may be used to perform frequency mixing processing on the one baseband signal (including the first baseband signal and the second baseband signal), and then output the first frequency-mixed signal.

Further, the first phase shifting unit 202 includes N phase shifters 2003.

Functions of the N phase shifters 2003 are as follows:
The N phase shifters 2003 are configured to respectively perform phase shifting processing on N frequency-mixed sub-signals corresponding to the first frequency-mixed signal obtained by the first frequency mixing unit 201, to obtain the N radio frequency signals (the radio frequency signal 1, the radio frequency signal 2, ..., and the radio frequency signal N).

It may be understood that N corresponding frequency-mixed sub-signals may be obtained after the first frequency-mixed signal undergoes power splitting, the N frequency-mixed sub-signals are the same, and phases or frequencies of N corresponding radio frequency signals obtained after respective phase shifting processing are different from each other.

The N phase shifters included in the first phase shifting unit may be used to implement a radio frequency signal of any waveform, and there is no feedback adjustment of an analog device in a generation process, so that good linearity and short settling time can be implemented, thereby solving problems that a current analog modulated radar has poor linearity and long settling time.

The N transmit ports (Tx1, Tx2, ..., and TxN) are configured to transmit the N radio frequency signals (the radio frequency signal 1, the radio frequency signal 2, ..., and the radio frequency signal N) obtained by the frequency mixing and phase shifting unit 20, so that the N radio frequency signals can be respectively transmitted from the N transmit ports. For example, the transmit port Tx1 is configured to transmit the radio frequency signal 1, the transmit port Tx2 is configured to transmit the radio frequency signal 2, and the transmit port TxN is configured to transmit the radio frequency signal N. This is not limited in this application. Phases or frequencies of the N radio frequency signals are different from each other. In other words, phases or frequencies of the radio frequency signal 1, the radio frequency signal 2, ..., and the radio frequency signal N are different from each other.

The N radio frequency signals generated through the foregoing signal processing may have any waveforms. In addition, compared with the signal processing system shown in FIG. 4, in a process of generating the N radio frequency signals in the signal processing system, there is no feedback adjustment of an analog device such as a phase-locked loop, and good linearity and short settling time can be implemented, thereby solving problems that a current analog modulated radar has poor linearity and long settling time. In addition, compared with the signal processing system shown in FIG. 5, in this signal processing system, to transmit different signals through multiple transmit channels, an independent DAC group does not need to be disposed on each channel, thereby reducing hardware complexity, reducing power consumption, and reducing costs.

FIG. 12 is a diagram of a structure of a signal processing system according to an embodiment of this application.

It may be understood that the signal processing system shown in FIG. 12 may be implemented as an independent embodiment, or the signal processing system shown in FIG. 12 may be understood as a variant of or a supplement to the signal processing systems in FIG. 6 to FIG. 9.

As shown in FIG. 12, the signal processing system includes a signal generation unit 10, a frequency mixing and phase shifting unit 20, and N transmit ports (for example, Tx1, Tx2, ..., and TxN). N is a positive integer.

The signal generation unit 10 is configured to generate one baseband signal, and the one baseband signal includes a first baseband signal and a second baseband signal that are orthogonal to each other.

Optionally, the signal generation unit 10 may be implemented in a plurality of implementations, as shown by the signal generation unit in the signal processing system shown in FIG. 8 or FIG. 9. Details are not described herein again.

It may be understood that the signal generation unit in the signal processing system shown in FIG. 8 or FIG. 9 is merely used as two possible implementations of the signal generation unit 10 for description, and should not constitute a limitation on embodiments of this application. A proper variant of or supplement to the signal generation unit in the signal processing system shown in FIG. 8 or FIG. 9 should be used as a possible implementation of the signal generation unit 10 provided in this application for protection.

In addition, functions of the frequency mixing and phase shifting unit 20 and the N transmit ports (Tx1, Tx2, ..., and TxN) shown in FIG. 12 are as follows:
The frequency mixing and phase shifting unit 20 is configured to process the one baseband signal, that is, perform frequency mixing processing and phase shifting processing on the first baseband signal and the second baseband signal, to obtain N radio frequency signals (a radio frequency signal 1, a radio frequency signal 2, ..., and a radio frequency signal N). It may be understood that, the frequency mixing and phase shifting unit 20 herein may perform frequency mixing processing and phase shifting processing on the first baseband signal and the second baseband signal for one or more times, and may perform frequency mixing processing before phase shifting processing, or may perform phase shifting processing before frequency mixing processing, or the like. This is not limited in this application.

Specifically, the frequency mixing and phase shifting unit 20 includes a second phase shifting unit 203 and a second frequency mixing unit 204.

Functions of the second phase shifting unit 203 and the second frequency mixing unit 204 are as follows:
The second phase shifting unit 203 is configured to perform phase shifting processing on the first local-oscillator signal (LO_RF) to obtain N phase-shifted signals (a phase-shifted signal 1, a phase-shifted signal 2, ..., and a phase-shifted signal N). Phases of the N phase-shifted signals are different from each other.

The second frequency mixing unit 204 is configured to separately perform frequency mixing processing on the N baseband sub-signals corresponding to the one baseband signal generated by the signal generation unit 10 and the N phase-shifted signals, which may be specifically performing frequency mixing processing on one baseband sub-signal of the N baseband sub-signals and one phase-shifted signal of the N phase-shifted signals to obtain N radio frequency signals, where phases or frequencies of the N radio frequency signals are different from each other.

In the foregoing manner of first performing phase shifting processing and then frequency mixing processing, the generated N radio frequency signals may have any waveforms, and there is no feedback adjustment of an analog device in a generation process, so that good linearity and short settling time can be implemented.

The N transmit ports (Tx1, Tx2, ..., and TxN) are configured to transmit the N radio frequency signals (the radio frequency signal 1, the radio frequency signal 2, ..., and the radio frequency signal N) obtained by the frequency mixing and phase shifting unit 20, so that the N radio frequency signals can be respectively transmitted from the N transmit ports. For example, the transmit port Tx1 is configured to transmit the radio frequency signal 1, the transmit port Tx2 is configured to transmit the radio frequency signal 2, and the transmit port TxN is configured to transmit the radio frequency signal N. This is not limited in this application. Phases or frequencies of the N radio frequency signals are different from each other. In other words, phases or frequencies of the radio frequency signal 1, the radio frequency signal 2, ..., and the radio frequency signal N are different from each other.

The N radio frequency signals generated through the foregoing signal processing may have any waveforms. In addition, compared with the signal processing system shown in FIG. 4, in a process of generating the N radio frequency signals in the signal processing system, there is no feedback adjustment of an analog device such as a phase-locked loop, and good linearity and short settling time can be implemented, thereby solving problems that a current analog modulated radar has poor linearity and long settling time. In addition, compared with the signal processing system shown in FIG. 5, in this signal processing system, to transmit different signals through multiple transmit channels, an independent DAC group does not need to be disposed on each channel, thereby reducing hardware complexity, reducing power consumption, and reducing costs.

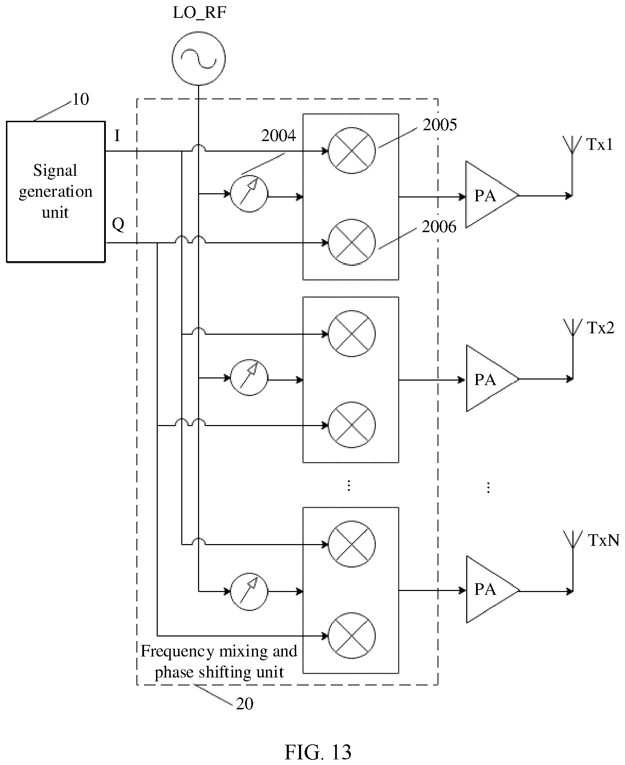

FIG. 13 is a diagram of a structure of a signal processing system according to an embodiment of this application.

It may be understood that the signal processing system shown in FIG. 13 may be implemented as an independent embodiment, or the signal processing system shown in FIG. 13 may be understood as a variant of or a supplement to the signal processing system in FIG. 12.

As shown in FIG. 13, the signal processing system includes a signal generation unit 10, a frequency mixing and phase shifting unit 20, and N transmit ports (for example, Tx1, Tx2, ..., and TxN). N is a positive integer.

The signal generation unit 10 is configured to generate one baseband signal, and the one baseband signal includes a first baseband signal and a second baseband signal that are orthogonal to each other.

Optionally, the signal generation unit 10 may be implemented in a plurality of implementations, as shown by the signal generation unit in the signal processing system shown in FIG. 8 or FIG. 9. Details are not described herein again.

It may be understood that the signal generation unit in the signal processing system shown in FIG. 8 or FIG. 9 is merely used as two possible implementations of the signal generation unit 10 for description, and should not constitute a limitation on embodiments of this application. A proper variant of or supplement to the signal generation unit in the signal processing system shown in FIG. 8 or FIG. 9 should be used as a possible implementation of the signal generation unit 10 provided in this application for protection.

In addition, functions of the frequency mixing and phase shifting unit 20 and the N transmit ports (Tx1, Tx2, ..., and TxN) shown in FIG. 13 are as follows:
The frequency mixing and phase shifting unit 20 is configured to process the one baseband signal, that is, perform frequency mixing processing and phase shifting processing on the first baseband signal and the second baseband signal, to obtain N radio frequency signals (a radio frequency signal 1, a radio frequency signal 2, ..., and a radio frequency signal N). It may be understood that, the frequency mixing and phase shifting unit 20 herein may perform frequency mixing processing and phase shifting processing on the first baseband signal and the second baseband signal for one or more times, and may perform frequency mixing processing before phase shifting processing, or may perform phase shifting processing before frequency mixing processing, or the like. This is not limited in this application.

Specifically, the frequency mixing and phase shifting unit 20 includes a second phase shifting unit 203 and a second frequency mixing unit 204.

Functions of the second phase shifting unit 203 and the second frequency mixing unit 204 are as follows:
The second phase shifting unit 203 is configured to perform phase shifting processing on the first local-oscillator signal (LO_RF) to obtain N phase-shifted signals (a phase-shifted signal 1, a phase-shifted signal 2, ..., and a phase-shifted signal N). Phases of the N phase-shifted signals are different from each other.

The second frequency mixing unit 204 is configured to separately perform frequency mixing processing on the N baseband sub-signals corresponding to the one baseband signal generated by the signal generation unit 10 and the N phase-shifted signals, which may be specifically performing frequency mixing processing on one baseband sub-signal of the N baseband sub-signals and one phase-shifted signal of the N phase-shifted signals to obtain N radio frequency signals, where phases or frequencies of the N radio frequency signals are different from each other.

In the foregoing manner of first performing phase shifting processing and then frequency mixing processing, the generated N radio frequency signals may have any waveforms, and there is no feedback adjustment of an analog device in a generation process, so that good linearity and short settling time can be implemented.

Further, the second phase shifting unit 203 includes N phase shifters 2004.

Functions of the N phase shifters 2004 are as follows:
The N phase shifters 2004 are configured to respectively perform phase shifting processing on N local-oscillator sub-signals corresponding to the first local-oscillator signal (LO_RF), to obtain the N phase-shifted signals (the phase-shifted signal 1, the phase-shifted signal 2, ..., and the phase-shifted signal N), where N corresponding local-oscillator sub-signals may be obtained after the first local-oscillator signal (LO_RF) undergoes power splitting, and the N local-oscillator sub-signals are the same. The N phase shifters 2004 included in the second phase shifting unit 203 may be used to implement an effect that phases of the N corresponding phase-shifted signals obtained after respective phase shifting processing are different from each other.

Further, the second frequency mixing unit 204 includes N frequency mixing modules, and a second frequency mixing module in the N frequency mixing modules includes a third frequency mixer 2005 and a fourth frequency mixer 2006.

Functions of the third frequency mixer 2005 and the fourth frequency mixer 2006 are as follows:
The third frequency mixer 2005 is configured to perform frequency mixing processing on a first baseband sub-signal corresponding to the first baseband signal and a first phase-shifted signal (the phase-shifted signal 1) of the N phase-shifted signals obtained by the second phase shifting unit.

The fourth frequency mixer 2006 is configured to perform frequency mixing processing on a second baseband sub-signal corresponding to the second baseband signal and the first phase-shifted signal (the phase-shifted signal 1) of the N phase-shifted signals obtained by the second phase shifting unit.

It may be understood that the third frequency mixer 2005 and the fourth frequency mixer 2006 may be two frequency mixers independent of each other, or may be two frequency mixing components in one IQ frequency mixer. The first baseband sub-signal corresponding to the first baseband signal may be one first baseband sub-signal of N first baseband sub-signals obtained after the first baseband signal undergoes power splitting, and the N first baseband sub-signals are the same. The second baseband sub-signal corresponding to the second baseband signal may be one second baseband sub-signal of N second baseband sub-signals obtained after the second baseband signal undergoes power splitting, and the N second baseband sub-signals are the same.

One radio frequency signal of any waveform may be output by using the third frequency mixer 2005 and the fourth frequency mixer 2006 that are included in the second frequency mixing module. The N frequency mixing modules in the second frequency mixing unit include the second frequency mixing module, so that phases or frequencies of N output radio frequency signals of any waveforms (the radio frequency signal 1, the radio frequency signal 2, ..., and the radio frequency signal N) are different from each other. In addition, there is no feedback adjustment of an analog device in a generation process, so that good linearity and short settling time can be implemented, thereby solving problems of poor linearity and long settling time in a current analog modulated radar.

The N transmit ports (Tx1, Tx2, ..., and TxN) are configured to transmit the N radio frequency signals (the radio frequency signal 1, the radio frequency signal 2, ..., and the radio frequency signal N) obtained by the frequency mixing and phase shifting unit 20, so that the N radio frequency signals can be respectively transmitted from the N transmit ports. For example, the transmit port Tx1 is configured to transmit the radio frequency signal 1, the transmit port Tx2 is configured to transmit the radio frequency signal 2, and the transmit port TxN is configured to transmit the radio frequency signal N. This is not limited in this application. Phases or frequencies of the N radio frequency signals are different from each other. In other words, phases or frequencies of the radio frequency signal 1, the radio frequency signal 2, ..., and the radio frequency signal N are different from each other.

The N radio frequency signals generated through the foregoing signal processing may have any waveforms. In addition, compared with the signal processing system shown in FIG. 4, in a process of generating the N radio frequency signals in the signal processing system, there is no feedback adjustment of an analog device such as a phase-locked loop, and good linearity and short settling time can be implemented, thereby solving problems that a current analog modulated radar has poor linearity and long settling time. In addition, compared with the signal processing system shown in FIG. 5, in this signal processing system, to transmit different signals through multiple transmit channels, an independent DAC group does not need to be disposed on each channel, thereby reducing hardware complexity, reducing power consumption, and reducing costs.

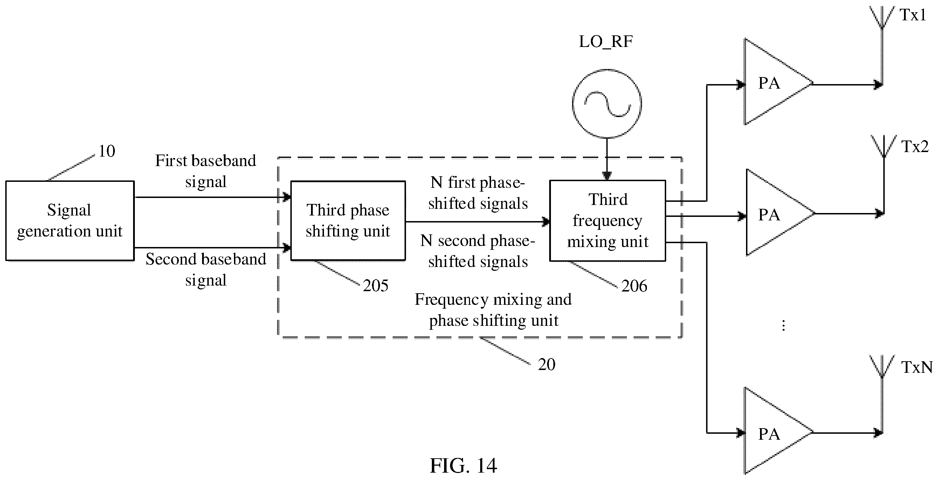

FIG. 14 is a diagram of a structure of a signal processing system according to an embodiment of this application.

It may be understood that the signal processing system shown in FIG. 14 may be implemented as an independent embodiment, or the signal processing system shown in FIG. 14 may be understood as a variant of or a supplement to the signal processing systems in FIG. 6 to FIG. 9.

As shown in FIG. 14, the signal processing system includes a signal generation unit 10, a frequency mixing and phase shifting unit 20, and N transmit ports (for example, Tx1, Tx2, ..., and TxN). N is a positive integer.

The signal generation unit 10 is configured to generate one baseband signal, and the one baseband signal includes a first baseband signal and a second baseband signal that are orthogonal to each other.

Optionally, the signal generation unit 10 may be implemented in a plurality of implementations, as shown by the signal generation unit in the signal processing system shown in FIG. 8 or FIG. 9. Details are not described herein again.

It may be understood that the signal generation unit in the signal processing system shown in FIG. 8 or FIG. 9 is merely used as two possible implementations of the signal generation unit 10 for description, and should not constitute a limitation on embodiments of this application. A proper variant of or supplement to the signal generation unit in the signal processing system shown in FIG. 8 or FIG. 9 should be used as a possible implementation of the signal generation unit 10 provided in this application for protection.

In addition, functions of the frequency mixing and phase shifting unit 20 and the N transmit ports (Tx1, Tx2, ..., and TxN) shown in FIG. 14 are as follows:
The frequency mixing and phase shifting unit 20 is configured to process the one baseband signal, that is, perform frequency mixing processing and phase shifting processing on the first baseband signal and the second baseband signal, to obtain N radio frequency signals (a radio frequency signal 1, a radio frequency signal 2, ..., and a radio frequency signal N). It may be understood that, the frequency mixing and phase shifting unit 20 herein may perform frequency mixing processing and phase shifting processing on the first baseband signal and the second baseband signal for one or more times, and may perform frequency mixing processing before phase shifting processing, or may perform phase shifting processing before frequency mixing processing, or the like. This is not limited in this application.

Specifically, the frequency mixing and phase shifting unit 20 includes a third phase shifting unit 205 and a third frequency mixing unit 206.

Functions of the third phase shifting unit 205 and the third frequency mixing unit 206 are as follows:
The third phase shifting unit 205 is configured to perform phase shifting processing on the first baseband signal to obtain N first phase-shifted signals, and perform phase shifting processing on the second baseband signal to obtain N second phase-shifted signals, where phases of the N first phase-shifted signals are different from each other, and phases of the N second phase-shifted signals are different from each other.

The third frequency mixing unit 206 is configured to separately perform frequency mixing processing on the N first phase-shifted signals and the N second phase-shifted signals that are obtained by the third phase shifting unit, which may be specifically separately performing frequency mixing processing on one first phase-shifted signal of the N first phase-shifted signals and one second phase-shifted signal of the N second phase-shifted signals, to obtain N radio frequency signals (a radio frequency signal 1, a radio frequency signal 2, ..., and a radio frequency signal N), where phases or frequencies of the N radio frequency signals are different from each other.

In the foregoing manner of first performing phase shifting processing and then frequency mixing processing, the generated N radio frequency signals may have any waveforms, and there is no feedback adjustment of an analog device in a generation process, so that good linearity and short settling time can be implemented.

The N transmit ports (Tx1, Tx2, ..., and TxN) are configured to transmit the N radio frequency signals (the radio frequency signal 1, the radio frequency signal 2, ..., and the radio frequency signal N) obtained by the frequency mixing and phase shifting unit 20, so that the N radio frequency signals can be respectively transmitted from the N transmit ports. For example, the transmit port Tx1 is configured to transmit the radio frequency signal 1, the transmit port Tx2 is configured to transmit the radio frequency signal 2, and the transmit port TxN is configured to transmit the radio frequency signal N. This is not limited in this application. Phases or frequencies of the N radio frequency signals are different from each other. In other words, phases or frequencies of the radio frequency signal 1, the radio frequency signal 2, ..., and the radio frequency signal N are different from each other.

The N radio frequency signals generated through the foregoing signal processing may have any waveforms. In addition, compared with the signal processing system shown in FIG. 4, in a process of generating the N radio frequency signals in the signal processing system, there is no feedback adjustment of an analog device such as a phase-locked loop, and good linearity and short settling time can be implemented, thereby solving problems that a current analog modulated radar has poor linearity and long settling time. In addition, compared with the signal processing system shown in FIG. 5, in this signal processing system, to transmit different signals through multiple transmit channels, an independent DAC group does not need to be disposed on each channel, thereby reducing hardware complexity, reducing power consumption, and reducing costs.

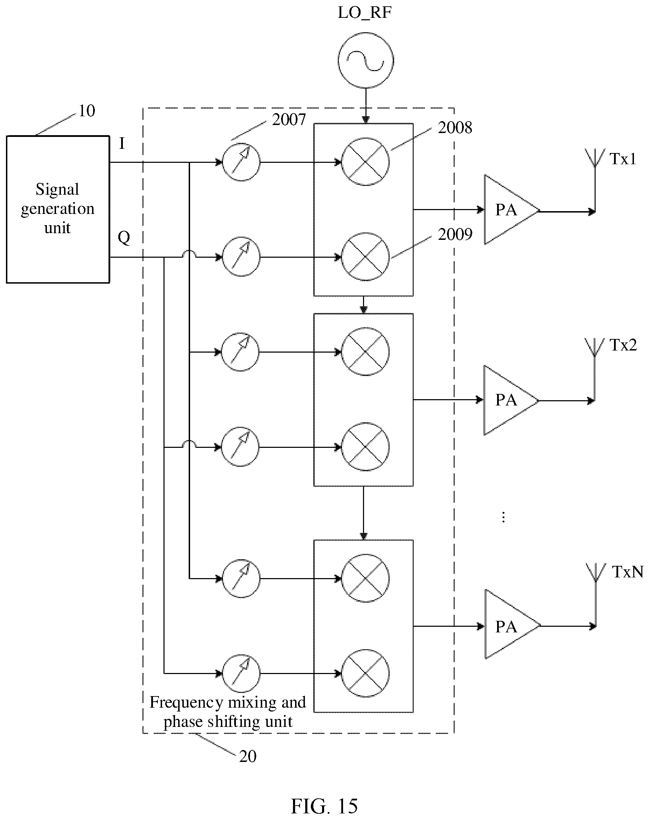

FIG. 15 is a diagram of a structure of a signal processing system according to an embodiment of this application.

It may be understood that the signal processing system shown in FIG. 15 may be implemented as an independent embodiment, or the signal processing system shown in FIG. 15 may be understood as a variant of or a supplement to the signal processing system in FIG. 14.

As shown in FIG. 15, the signal processing system includes a signal generation unit 10, a frequency mixing and phase shifting unit 20, and N transmit ports (for example, Tx1, Tx2, ..., and TxN). N is a positive integer.

The signal generation unit 10 is configured to generate one baseband signal, and the one baseband signal includes a first baseband signal and a second baseband signal that are orthogonal to each other.

Optionally, the signal generation unit 10 may be implemented in a plurality of implementations, as shown by the signal generation unit in the signal processing system shown in FIG. 8 or FIG. 9. Details are not described herein again.

It may be understood that the signal generation unit in the signal processing system shown in FIG. 8 or FIG. 9 is merely used as two possible implementations of the signal generation unit 10 for description, and should not constitute a limitation on embodiments of this application. A proper variant of or supplement to the signal generation unit in the signal processing system shown in FIG. 8 or FIG. 9 should be used as a possible implementation of the signal generation unit 10 provided in this application for protection.

In addition, functions of the frequency mixing and phase shifting unit 20 and the N transmit ports (Tx1, Tx2, ..., and TxN) shown in FIG. 15 are as follows:
The frequency mixing and phase shifting unit 20 is configured to process the one baseband signal, that is, perform frequency mixing processing and phase shifting processing on the first baseband signal and the second baseband signal, to obtain N radio frequency signals (a radio frequency signal 1, a radio frequency signal 2, ..., and a radio frequency signal N). It may be understood that, the frequency mixing and phase shifting unit 20 herein may perform frequency mixing processing and phase shifting processing on the first baseband signal and the second baseband signal for one or more times, and may perform frequency mixing processing before phase shifting processing, or may perform phase shifting processing before frequency mixing processing, or the like. This is not limited in this application.

Specifically, the frequency mixing and phase shifting unit 20 includes a third phase shifting unit 205 and a third frequency mixing unit 206.

Functions of the third phase shifting unit 205 and the third frequency mixing unit 206 are as follows:
The third phase shifting unit 205 is configured to perform phase shifting processing on the first baseband signal to obtain N first phase-shifted signals, and perform phase shifting processing on the second baseband signal to obtain N second phase-shifted signals, where phases of the N first phase-shifted signals are different from each other, and phases of the N second phase-shifted signals are different from each other.

The third frequency mixing unit 206 is configured to separately perform frequency mixing processing on the N first phase-shifted signals and the N second phase-shifted signals that are obtained by the third phase shifting unit, which may be specifically separately performing frequency mixing processing on one first phase-shifted signal of the N first phase-shifted signals and one second phase-shifted signal of the N second phase-shifted signals, to obtain N radio frequency signals (a radio frequency signal 1, a radio frequency signal 2, ..., and a radio frequency signal N), where phases or frequencies of the N radio frequency signals are different from each other.

In the foregoing manner of first performing phase shifting processing and then frequency mixing processing, the generated N radio frequency signals may have any waveforms, and there is no feedback adjustment of an analog device in a generation process, so that good linearity and short settling time can be implemented.

Further, the third phase shifting unit 205 includes 2N phase shifters 2007.

Functions of the 2N phase shifters 2007 are as follows:
A (2i-1)^{th} phase shifter in the 2N phase shifters 2007 is configured to separately perform phase shifting processing on N baseband sub-signals corresponding to the first baseband signal to obtain the N first phase-shifted signals.

A 2i^{th} phase shifter in the 2N phase shifters 2007 is configured to separately perform phase shifting processing on N baseband sub-signals corresponding to the second baseband signal to obtain the N second phase-shifted signals.

It may be understood that N corresponding baseband sub-signals may be obtained after the first baseband signal undergoes power splitting, the N baseband sub-signals are the same, and phases of N first phase-shifted signals obtained after respective phase shifting processing are different from each other. N corresponding baseband sub-signals may be obtained after the second baseband signal undergoes power splitting, the N baseband sub-signals are the same, and phases of N second phase-shifted signals obtained after respective phase shifting processing are different from each other.

The 2N phase shifters 2007 included in the third phase shifting unit may be used to implement an effect that the phases of the N first phase-shifted signals obtained after respective phase shifting processing are different from each other and an effect that the phases of the N second phase-shifted signals obtained after respective phase shifting processing are different from each other.

Further, the third frequency mixing unit 206 includes N frequency mixing modules, and a third frequency mixing module in the N frequency mixing modules includes a fifth frequency mixer 2008 and a sixth frequency mixer 2009.

Functions of the fifth frequency mixer 2008 and the sixth frequency mixer 2009 are as follows:
The fifth frequency mixer 2008 is configured to perform frequency mixing processing on a first local-oscillator signal (LO_RF) and one first phase-shifted signal of the N first phase-shifted signals obtained by the third phase shifting unit.

The sixth frequency mixer 2009 is configured to perform frequency mixing processing on the first local-oscillator signal (LO_RF) and one second phase-shifted signal of the N second phase-shifted signals obtained by the third phase shifting unit.

It may be understood that the fifth frequency mixer 2008 and the sixth frequency mixer 2009 may be two frequency mixers independent of each other, or may be two frequency mixing components in one IQ frequency mixer.

One radio frequency signal of any waveform may be output by using the fifth frequency mixer 2008 and the sixth frequency mixer 2009 that are included in the third frequency mixing module. The N frequency mixing modules in the third frequency mixing unit include the third frequency mixing module, so that phases or frequencies of N output radio frequency signals of any waveforms (the radio frequency signal 1, the radio frequency signal 2, ..., and the radio frequency signal N) are different from each other. In addition, there is no feedback adjustment of an analog device in a generation process, so that good linearity and short settling time can be implemented, thereby solving problems of poor linearity and long settling time in a current analog modulated radar.

The N transmit ports (Tx1, Tx2, ..., and TxN) are configured to transmit the N radio frequency signals (the radio frequency signal 1, the radio frequency signal 2, ..., and the radio frequency signal N) obtained by the frequency mixing and phase shifting unit 20, so that the N radio frequency signals can be respectively transmitted from the N transmit ports. For example, the transmit port Tx1 is configured to transmit the radio frequency signal 1, the transmit port Tx2 is configured to transmit the radio frequency signal 2, and the transmit port TxN is configured to transmit the radio frequency signal N. This is not limited in this application. Phases or frequencies of the N radio frequency signals are different from each other. In other words, phases or frequencies of the radio frequency signal 1, the radio frequency signal 2, ..., and the radio frequency signal N are different from each other.

The N radio frequency signals generated through the foregoing signal processing may have any waveforms. In addition, compared with the signal processing system shown in FIG. 4, in a process of generating the N radio frequency signals in the signal processing system, there is no feedback adjustment of an analog device such as a phase-locked loop, and good linearity and short settling time can be implemented, thereby solving problems that a current analog modulated radar has poor linearity and long settling time. In addition, compared with the signal processing system shown in FIG. 5, in this signal processing system, to transmit different signals through multiple transmit channels, an independent DAC group does not need to be disposed on each channel, thereby reducing hardware complexity, reducing power consumption, and reducing costs.

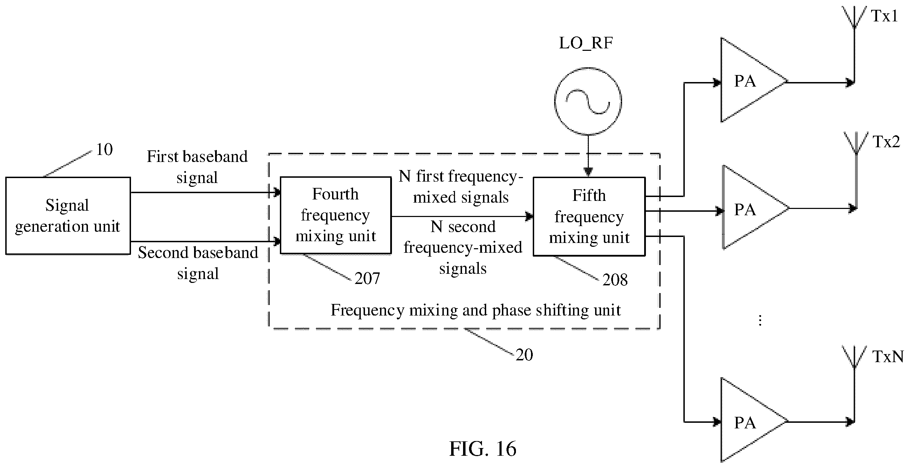

FIG. 16 is a diagram of a structure of a signal processing system according to an embodiment of this application.

It may be understood that the signal processing system shown in FIG. 16 may be implemented as an independent embodiment, or the signal processing system shown in FIG. 16 may be understood as a variant of or a supplement to the signal processing systems in FIG. 6 to FIG. 9.

As shown in FIG. 16, the signal processing system includes a signal generation unit 10, a frequency mixing and phase shifting unit 20, and N transmit ports (for example, Tx1, Tx2, ..., and TxN). N is a positive integer.

The signal generation unit 10 is configured to generate one baseband signal, and the one baseband signal includes a first baseband signal and a second baseband signal that are orthogonal to each other.

Optionally, the signal generation unit 10 may be implemented in a plurality of implementations, as shown by the signal generation unit in the signal processing system shown in FIG. 8 or FIG. 9. Details are not described herein again.

It may be understood that the signal generation unit in the signal processing system shown in FIG. 8 or FIG. 9 is merely used as two possible implementations of the signal generation unit 10 for description, and should not constitute a limitation on embodiments of this application. A proper variant of or supplement to the signal generation unit in the signal processing system shown in FIG. 8 or FIG. 9 should be used as a possible implementation of the signal generation unit 10 provided in this application for protection.

In addition, functions of the frequency mixing and phase shifting unit 20 and the N transmit ports (Tx1, Tx2, ..., and TxN) shown in FIG. 16 are as follows:
The frequency mixing and phase shifting unit 20 is configured to process the one baseband signal, that is, perform frequency mixing processing and phase shifting processing on the first baseband signal and the second baseband signal, to obtain N radio frequency signals (a radio frequency signal 1, a radio frequency signal 2, ..., and a radio frequency signal N). It may be understood that, the frequency mixing and phase shifting unit 20 herein may perform frequency mixing processing and phase shifting processing on the first baseband signal and the second baseband signal for one or more times, and may perform frequency mixing processing before phase shifting processing, or may perform phase shifting processing before frequency mixing processing, or the like. This is not limited in this application.

Specifically, the frequency mixing and phase shifting unit 20 includes a fourth frequency mixing unit 207 and a fifth frequency mixing unit 208.

Functions of the fourth frequency mixing unit 207 and the fifth frequency mixing unit 208 are as follows:
The fourth frequency mixing unit 207 is configured to: separately perform frequency mixing processing on each second local-oscillator signal of N second local-oscillator signals (LO_DF1, LO_DF2, ..., and LO_DFN), a quadrature signal corresponding to each second local-oscillator signal, and N baseband sub-signals corresponding to the first baseband signal, to obtain N first frequency-mixed signals; and separately perform frequency mixing processing on each second local-oscillator signal of the N second local-oscillator signals (LO_DF1, LO_DF2, ..., and LO _DFN), the quadrature signal corresponding to each second local-oscillator signal, and N baseband sub-signals corresponding to the second baseband signal, to obtain N second frequency-mixed signals. Phases of the N first frequency-mixed signals are different from each other, and phases of the N second frequency-mixed signals are different from each other.

The fifth frequency mixing unit 208 is configured to separately perform frequency mixing processing on the N first frequency-mixed signals and the N second frequency-mixed signals that are obtained by the fourth frequency mixing unit, which may be specifically separately performing frequency mixing processing on one first frequency-mixed signal of the N first frequency-mixed signals and one second frequency-mixed signal of the N second frequency-mixed signals to obtain N radio frequency signals (a radio frequency signal 1, a radio frequency signal 2, ..., and a radio frequency signal N), where phases or frequencies of the N radio frequency signals are different from each other.

In the foregoing manner of first performing phase shifting and then frequency mixing processing, the generated N radio frequency signals may have any waveforms, and there is no feedback adjustment of an analog device in a generation process, so that good linearity and short settling time can be implemented.

Optionally, frequencies of the second local-oscillator signals of the N second local-oscillator signals (LO_DF1, LO_DF2, ..., and LO_DFN) are different from each other, and the frequencies of the N second local-oscillator signals are different from a frequency of the first local-oscillator signal and a frequency of the third local-oscillator signal.

The N first frequency-mixed signals and the N second frequency-mixed signals are obtained by using the N second local-oscillator signals (LO_DF1, LO_DF2, ..., and LO_DFN) that have different frequencies, so that the phases of the N first frequency-mixed signals are different from each other, and the phases of the N second frequency-mixed signals are different from each other.

The N transmit ports (Tx1, Tx2, ..., and TxN) are configured to transmit the N radio frequency signals (the radio frequency signal 1, the radio frequency signal 2, ..., and the radio frequency signal N) obtained by the frequency mixing and phase shifting unit 20, so that the N radio frequency signals can be respectively transmitted from the N transmit ports. For example, the transmit port Tx1 is configured to transmit the radio frequency signal 1, the transmit port Tx2 is configured to transmit the radio frequency signal 2, and the transmit port TxN is configured to transmit the radio frequency signal N. This is not limited in this application. Phases or frequencies of the N radio frequency signals are different from each other. In other words, phases or frequencies of the radio frequency signal 1, the radio frequency signal 2, ..., and the radio frequency signal N are different from each other.

The N radio frequency signals generated through the foregoing signal processing may have any waveforms. In addition, compared with the signal processing system shown in FIG. 4, in a process of generating the N radio frequency signals in the signal processing system, there is no feedback adjustment of an analog device such as a phase-locked loop, and good linearity and short settling time can be implemented, thereby solving problems that a current analog modulated radar has poor linearity and long settling time. In addition, compared with the signal processing system shown in FIG. 5, in this signal processing system, to transmit different signals through multiple transmit channels, an independent DAC group does not need to be disposed on each channel, thereby reducing hardware complexity, reducing power consumption, and reducing costs.

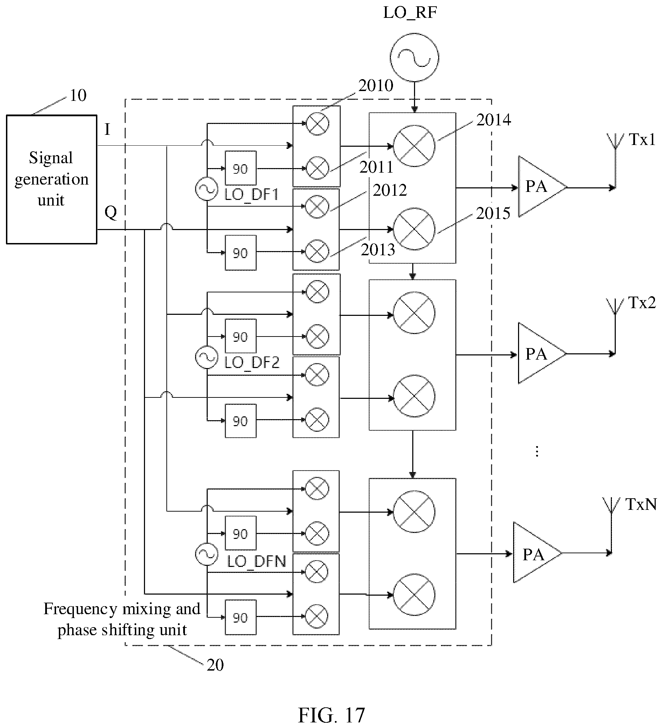

FIG. 17 is a diagram of a structure of a signal processing system according to an embodiment of this application.

It may be understood that the signal processing system shown in FIG. 17 may be implemented as an independent embodiment, or the signal processing system shown in FIG. 17 may be understood as a variant of or a supplement to the signal processing system in FIG. 14.

As shown in FIG. 17, the signal processing system includes a signal generation unit 10, a frequency mixing and phase shifting unit 20, and N transmit ports (for example, Tx1, Tx2, ..., and TxN). N is a positive integer.

The signal generation unit 10 is configured to generate one baseband signal, and the one baseband signal includes a first baseband signal and a second baseband signal that are orthogonal to each other.

Optionally, the signal generation unit 10 may be implemented in a plurality of implementations, as shown by the signal generation unit in the signal processing system shown in FIG. 8 or FIG. 9. Details are not described herein again.

It may be understood that the signal generation unit in the signal processing system shown in FIG. 8 or FIG. 9 is merely used as two possible implementations of the signal generation unit 10 for description, and should not constitute a limitation on embodiments of this application. A proper variant of or supplement to the signal generation unit in the signal processing system shown in FIG. 8 or FIG. 9 should be used as a possible implementation of the signal generation unit 10 provided in this application for protection.

In addition, functions of the frequency mixing and phase shifting unit 20 and the N transmit ports (Tx1, Tx2, ..., and TxN) shown in FIG. 17 are as follows:
The frequency mixing and phase shifting unit 20 is configured to process the one baseband signal, that is, perform frequency mixing processing and phase shifting processing on the first baseband signal and the second baseband signal, to obtain N radio frequency signals (a radio frequency signal 1, a radio frequency signal 2, ..., and a radio frequency signal N). It may be understood that, the frequency mixing and phase shifting unit 20 herein may perform frequency mixing processing and phase shifting processing on the first baseband signal and the second baseband signal for one or more times, and may perform frequency mixing processing before phase shifting processing, or may perform phase shifting processing before frequency mixing processing, or the like. This is not limited in this application.

Specifically, the frequency mixing and phase shifting unit 20 includes a fourth frequency mixing unit 207 and a fifth frequency mixing unit 208.

Functions of the fourth frequency mixing unit 207 and the fifth frequency mixing unit 208 are as follows:

The fourth frequency mixing unit 207 is configured to: separately perform frequency mixing processing on each second local-oscillator signal of N second local-oscillator signals (LO_DF1, LO_DF2, ..., and LO _DFN), a quadrature signal corresponding to each second local-oscillator signal, and N baseband sub-signals corresponding to the first baseband signal, to obtain N first frequency-mixed signals; and separately perform frequency mixing processing on each second local-oscillator signal of the N second local-oscillator signals (LO_DF1, LO_DF2, ..., and LO _DFN), the quadrature signal corresponding to each second local-oscillator signal, and N baseband sub-signals corresponding to the second baseband signal, to obtain N second frequency-mixed signals. Phases of the N first frequency-mixed signals are different from each other, and phases of the N second frequency-mixed signals are different from each other.

The fifth frequency mixing unit 208 is configured to separately perform frequency mixing processing on the N first frequency-mixed signals and the N second frequency-mixed signals that are obtained by the fourth frequency mixing unit, which may be specifically separately performing frequency mixing processing on one first frequency-mixed signal of the N first frequency-mixed signals and one second frequency-mixed signal of the N second frequency-mixed signals to obtain N radio frequency signals (a radio frequency signal 1, a radio frequency signal 2, ..., and a radio frequency signal N), where phases or frequencies of the N radio frequency signals are different from each other.

In the foregoing manner of first performing phase shifting and then frequency mixing processing, the generated N radio frequency signals may have any waveforms, and there is no feedback adjustment of an analog device in a generation process, so that good linearity and short settling time can be implemented.

Optionally, frequencies of the second local-oscillator signals of the N second local-oscillator signals (LO_DF1, LO_DF2, ..., and LO_DFN) are different from each other, and the frequencies of the N second local-oscillator signals are different from a frequency of the first local-oscillator signal and a frequency of the third local-oscillator signal.

The N first frequency-mixed signals and the N second frequency-mixed signals are obtained by using the N second local-oscillator signals (LO_DF1, LO_DF2, ..., and LO_DFN) that have different frequencies, so that the phases of the N first frequency-mixed signals are different from each other, and the phases of the N second frequency-mixed signals are different from each other.

Further, the fourth frequency mixing unit 207 includes 2N frequency mixing modules, and a fourth frequency mixing module in the 2N frequency mixing modules includes a seventh frequency mixer 2010 and an eighth frequency mixer 2011.

Functions of the seventh frequency mixer 2010 and the eighth frequency mixer 2011 are as follows:
The seventh frequency mixer 2010 is configured to perform frequency mixing processing on one second local-oscillator signal (LO_DF1) of the N second local-oscillator signals (LO_DF1, LO_DF2, ..., and LO_DFN) and a first baseband sub-signal corresponding to the first baseband signal.

The eighth frequency mixer 2011 is configured to perform frequency mixing processing on a quadrature signal corresponding to the one second local-oscillator signal (LO_DF1) and the first baseband sub-signal corresponding to the first baseband signal.

It may be understood that the seventh frequency mixer 2010 and the eighth frequency mixer 2011 may be two frequency mixers independent of each other, or may be two frequency mixing components in one IQ frequency mixer. The first baseband sub-signal may be one first baseband sub-signal of N corresponding first baseband sub-signals obtained after the first baseband signal undergoes power splitting.

One first frequency-mixed signal may be output by using the seventh frequency mixer 2010 and the eighth frequency mixer 2011 that are included in the fourth frequency mixing module. The 2N frequency mixing modules in the fourth frequency mixing unit include the fourth frequency mixing module, so that N first frequency-mixed signals can be output, and phases of the N first frequency-mixed signals are different from each other.

Similarly, a fifth frequency mixing module in the 2N frequency mixing modules includes a ninth frequency mixer 2012 and a tenth frequency mixer 2013.

Functions of the ninth frequency mixer 2012 and the tenth frequency mixer 2013 are as follows:
The ninth frequency mixer 2012 is configured to perform frequency mixing processing on one second local-oscillator signal (LO_DF1) of the N second local-oscillator signals (LO_DF1, LO_DF2, ..., and LO_DFN) and a second baseband sub-signal corresponding to the second baseband signal.

The tenth frequency mixer 2013 is configured to perform frequency mixing processing on a quadrature signal corresponding to the one second local-oscillator signal (LO_DF1) and the second baseband sub-signal corresponding to the second baseband signal.

It may be understood that the ninth frequency mixer 2012 and the tenth frequency mixer 2013 may be two frequency mixers independent of each other, or may be two frequency mixing components in one IQ frequency mixer. The second baseband sub-signal may be one second baseband sub-signal of N second baseband sub-signals obtained after the second baseband signal undergoes power splitting.

One second frequency-mixed signal may be output by using the ninth frequency mixer 2012 and the tenth frequency mixer 2013 that are included in the fifth frequency mixing module. The 2N frequency mixing modules in the fourth frequency mixing unit include the fifth frequency mixing module, so that N second frequency-mixed signals can be output, and phases of the N second frequency-mixed signals are different from each other.

Further, the fifth frequency mixing unit 208 includes N frequency mixing modules, and a sixth frequency mixing module in the N frequency mixing modules includes an eleventh frequency mixer 2014 and a twelfth frequency mixer 2015.

Functions of the eleventh frequency mixer 2014 and the twelfth frequency mixer 2015 are as follows:
The eleventh frequency mixer 2014 is configured to perform frequency mixing processing on a first local-oscillator signal (LO_RF) and one N first frequency-mixed signal of the N first frequency-mixed signals obtained by the fourth frequency mixing unit.

The twelfth frequency mixer 2015 is configured to perform frequency mixing processing on the first local-oscillator signal (LO_RF) and one second frequency-mixed signal of the N second frequency-mixed signals obtained by the fourth frequency mixing unit.

It may be understood that the eleventh frequency mixer 2014 and the twelfth frequency mixer 2015 may be two frequency mixers independent of each other, or may be two frequency mixing components in one IQ frequency mixer.

One radio frequency signal of any waveform may be output by using the eleventh frequency mixer 2014 and the twelfth frequency mixer 2015 that are included in the sixth frequency mixing module. The N frequency mixing modules in the fifth frequency mixing unit include the sixth frequency mixing module, so that phases or frequencies of N output radio frequency signals of any waveforms (the radio frequency signal 1, the radio frequency signal 2, ..., and the radio frequency signal N) are different from each other. In addition, there is no feedback adjustment of an analog device in a generation process, so that good linearity and short settling time can be implemented, thereby solving problems of poor linearity and long settling time in a current analog modulated radar.

The N transmit ports (Tx1, Tx2, ..., and TxN) are configured to transmit the N radio frequency signals (the radio frequency signal 1, the radio frequency signal 2, ..., and the radio frequency signal N) obtained by the frequency mixing and phase shifting unit 20, so that the N radio frequency signals can be respectively transmitted from the N transmit ports. For example, the transmit port Tx1 is configured to transmit the radio frequency signal 1, the transmit port Tx2 is configured to transmit the radio frequency signal 2, and the transmit port TxN is configured to transmit the radio frequency signal N. This is not limited in this application. Phases or frequencies of the N radio frequency signals are different from each other. In other words, phases or frequencies of the radio frequency signal 1, the radio frequency signal 2, ..., and the radio frequency signal N are different from each other.

The N radio frequency signals generated through the foregoing signal processing may have any waveforms. In addition, compared with the signal processing system shown in FIG. 4, in a process of generating the N radio frequency signals in the signal processing system, there is no feedback adjustment of an analog device such as a phase-locked loop, and good linearity and short settling time can be implemented, thereby solving problems that a current analog modulated radar has poor linearity and long settling time. In addition, compared with the signal processing system shown in FIG. 5, in this signal processing system, to transmit different signals through multiple transmit channels, an independent DAC group does not need to be disposed on each channel, thereby reducing hardware complexity, reducing power consumption, and reducing costs.

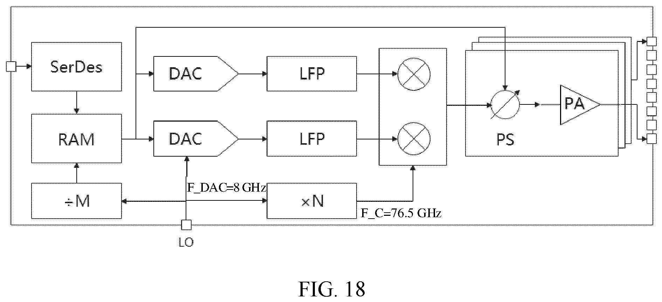

FIG. 18 is a diagram of a structure of a signal processing system according to an embodiment of this application.

It may be understood that the signal processing system shown in FIG. 18 may be implemented as an independent embodiment, or the signal processing system shown in FIG. 18 may be understood as a variant of or a supplement to the signal processing systems in FIG. 6 to FIG. 9.

As shown in FIG. 18, N transmit (Tx) channels are included. A digital mode of a transmit signal is stored in a random access memory (random access memory, RAM). After the transmit signal is converted into an analog signal by using a DAC, the analog signal is filtered by a low-pass filter and then mixed with a local-oscillator signal (F_C=76.5 GHz) in an IQ frequency mixer, and then enters a parallel radio frequency phase shifting unit. The radio frequency phase shifting unit includes N phase shifters and power amplifiers (PA), each phase shifter corresponds to one Tx channel and one transmit antenna, and radio frequency signals that are phase-shifted by different phase shifters are radiated from transmit antennas.

According to this embodiment of this application, a generated baseband signal is multiplexed for different transmit signals. The frequency mixing and phase shifting unit performs frequency mixing and phase shifting operations on the baseband signal and a local-oscillator signal, to generate a radio frequency signal. The radio frequency signal has a different phase change mode on each transmit channel, so as to implement orthogonality between transmit signals. In addition, compared with the signal processing system shown in FIG. 4, in a process of generating the N radio frequency signals in the signal processing system, there is no feedback adjustment of an analog device such as a phase-locked loop, and good linearity and short settling time can be implemented, thereby solving problems that a current analog modulated radar has poor linearity and long settling time. In addition, compared with the signal processing system shown in FIG. 5, in this signal processing system, to transmit different signals through multiple transmit channels, an independent DAC group does not need to be disposed on each channel, thereby reducing hardware complexity, reducing power consumption, and reducing costs.

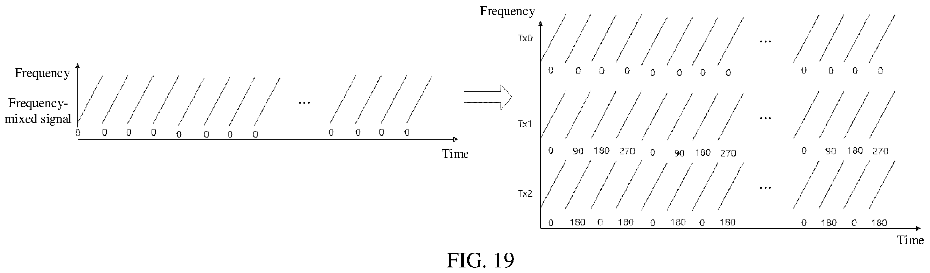

FIG. 19 is a diagram of a signal according to an embodiment of this application.

It may be understood that the diagram of the signal shown in FIG. 19 may be a signal corresponding to the signal processing system shown in FIG. 18, or the diagram of the signal shown in FIG. 19 may be understood as a signal corresponding to a signal processing system in which frequency mixing processing is performed before phase shifting processing, including but not limited to a signal corresponding to the signal processing system shown in FIG. 10 or FIG. 11.

As shown in FIG. 19, a signal generation unit of the signal processing system generates an FMCW signal of a baseband frequency, and performs frequency mixing on the FMCW signal of the baseband frequency and a local-oscillator signal to obtain an FMCW signal of a radio frequency. After the FMCW signal of the radio frequency enters different Tx channels, phase shifters perform phase shifting processing on the FMCW signal of the radio frequency according to different phase shifting rules, to distinguish between transmit signals of different Tx channels. The phase shifting rule may be that a determined phase difference, for example, 90°, exists between adjacent chirp (chirp), to implement phase rotation and frequency shifting, and modulate an FMCW signal to different Doppler frequencies.

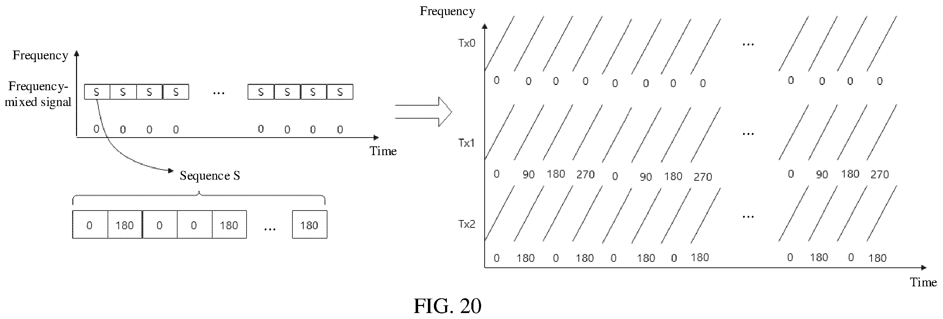

FIG. 20 is a diagram of a signal according to an embodiment of this application.

It may be understood that the diagram of the signal shown in FIG. 20 may be a signal corresponding to the signal processing system shown in FIG. 18, or the diagram of the signal shown in FIG. 20 may be understood as a signal corresponding to a signal processing system in which frequency mixing processing is performed before phase shifting processing, including but not limited to a signal corresponding to the signal processing system shown in FIG. 10 or FIG. 11.

As shown in FIG. 20, a signal generation unit of the signal processing system generates a PMCW signal of a baseband frequency, and performs frequency mixing on the FMCW signal of the baseband frequency and a local-oscillator signal to obtain a PMCW signal of a radio frequency. After the PMCW signal of the radio frequency enters different Tx channels, phase shifters perform phase shifting processing on the PMCW signal of the radio frequency according to different phase shifting rules, to distinguish between transmit signals of different Tx channels. The phase shifting rule may be that a determined phase difference, for example, 90°, exists between adjacent sequences S, to implement phase rotation and frequency shifting, and modulate a PMCW signal to different Doppler frequencies.

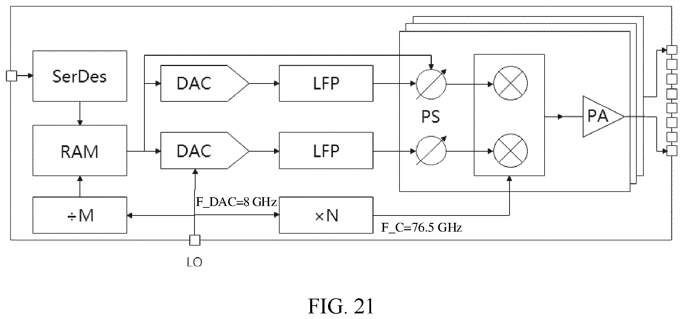

FIG. 21 is a diagram of a structure of still another signal processing system according to an embodiment of this application.

It may be understood that the signal processing system shown in FIG. 21 may be implemented as an independent embodiment, or the signal processing system shown in FIG. 21 may be understood as a variant of or a supplement to the signal processing systems in FIG. 6 to FIG. 9.

As shown in FIG. 21, N transmit (Tx) channels are included. A digital mode of a transmit signal is stored in a random access memory (random access memory, RAM). After the transmit signal is converted into an analog signal by using a DAC, the analog signal is filtered by a low-pass filter and then enters a parallel radio frequency phase shifting unit. The radio frequency phase shifting unit includes N phase shifters, and each phase shifter corresponds to one analog signal. Analog signals that are phase-shifted by different phase shifters are mixed with a local-oscillator signal (F_C=76.5 GHz) in an IQ frequency mixer, and then pass through a power amplifier (PA) and are radiated from transmit antennas.

According to this embodiment of this application, a generated baseband signal is multiplexed for different transmit signals. The frequency mixing and phase shifting unit performs frequency mixing and phase shifting operations on the baseband signal and a local-oscillator signal, to generate a radio frequency signal. The radio frequency signal has a different phase change mode on each transmit channel, so as to implement orthogonality between transmit signals. In addition, compared with the signal processing system shown in FIG. 4, in a process of generating the N radio frequency signals in the signal processing system, there is no feedback adjustment of an analog device such as a phase-locked loop, and good linearity and short settling time can be implemented, thereby solving problems that a current analog modulated radar has poor linearity and long settling time. In addition, compared with the signal processing system shown in FIG. 5, in this signal processing system, to transmit different signals through multiple transmit channels, an independent DAC group does not need to be disposed on each channel, thereby reducing hardware complexity, reducing power consumption, and reducing costs.

This application provides a chip. The chip includes the signal processing system provided in this application.

This application provides a radar or a radar system, where the radar or the radar system includes the signal processing system or the foregoing chip provided in this application. It should be noted that there may be a smart sensor integrated with a plurality of sensors. When the smart sensor includes a millimeter-wave detection function, the smart sensor may also be referred to as a millimeter-wave radar system or a millimeter-wave radar system.

This application provides a terminal device. The terminal device includes the signal processing system provided in this application. For example, the terminal device may be a transportation tool, for example, a transportation means used in any possible scenario, for example, a vehicle, a truck, an aircraft, an unmanned aerial vehicle, a slow transport vehicle, a spacecraft, or a ship, or may have any device that can carry a millimeter-wave detection apparatus, for example, a surveying and mapping device. One or more signal processing systems provided in this application are deployed on the terminal device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A signal processing system, comprising: a signal generation unit, a frequency mixing and phase shifting unit, and N transmit ports, wherein
the signal generation unit is configured to generate one baseband signal, wherein the one baseband signal comprises a first baseband signal and a second baseband signal, and the first baseband signal and the second baseband signal are quadrature signals;
the frequency mixing and phase shifting unit is configured to perform frequency mixing processing and phase shifting processing on the one baseband signal to obtain N radio frequency signals, wherein phases or frequencies of the N radio frequency signals are different from each other; and
the N transmit ports are configured to respectively transmit the N radio frequency signals, wherein N is a positive integer.

2. The signal processing system according to claim 1, wherein the N radio frequency signals are frequency modulated continuous wave FMCW signals, and the N radio frequency signals meet a first pulse repetition interval PRI; or
the N radio frequency signals are phase modulated continuous wave PMCW signals, and the N radio frequency signals meet a second pulse repetition interval PRI.

3. The signal processing system according to claim 1 or 2, wherein the first baseband signal is an in-phase signal, and the second baseband signal is a quadrature signal.

4. The signal processing system according to any one of claims 1 to 3, wherein the frequency mixing and phase shifting unit comprises:
a first frequency mixing unit and a first phase shifting unit;
the first frequency mixing unit is configured to perform frequency mixing processing on the one baseband signal to obtain a first frequency-mixed signal; and
the first phase shifting unit is configured to perform phase shifting processing on the first frequency-mixed signal to obtain the N radio frequency signals.

5. The signal processing system according to claim 4, wherein the first frequency mixing unit comprises a first frequency mixing module, and the first frequency mixing module comprises:
a first frequency mixer and a second frequency mixer;
the first frequency mixer is configured to perform frequency mixing processing on the first baseband signal and a first local-oscillator signal; and
the second frequency mixer is configured to perform frequency mixing processing on the second baseband signal and the first local-oscillator signal.

6. The signal processing system according to claim 4 or 5, wherein the first phase shifting unit comprises:
N phase shifters; and
the N phase shifters are configured to respectively perform phase shifting processing on N frequency-mixed sub-signals corresponding to the first frequency-mixed signal, to obtain the N radio frequency signals.

7. The signal processing system according to any one of claims 1 to 3, wherein the frequency mixing and phase shifting unit comprises:
a second phase shifting unit and a second frequency mixing unit;
the second phase shifting unit is configured to perform phase shifting processing on a first local-oscillator signal to obtain N phase-shifted signals; and
the second frequency mixing unit is configured to separately perform frequency mixing processing on N baseband sub-signals corresponding to the one baseband signal and the N phase-shifted signals, to obtain the N radio frequency signals.

8. The signal processing system according to claim 7, wherein the second phase shifting unit comprises:
N phase shifters; and
the N phase shifters are configured to respectively perform phase shifting processing on N local-oscillator sub-signals corresponding to the first local-oscillator signal, to obtain the N phase-shifted signals.

9. The signal processing system according to claim 7 or 8, wherein the second frequency mixing unit comprises N frequency mixing modules, and a second frequency mixing module in the N frequency mixing modules comprises:
a third frequency mixer and a fourth frequency mixer;
the third frequency mixer is configured to perform frequency mixing processing on a first baseband sub-signal corresponding to the first baseband signal and a first phase-shifted signal in the N phase-shifted signals; and
the fourth frequency mixer is configured to perform frequency mixing processing on a second baseband sub-signal corresponding to the second baseband signal and the first phase-shifted signal.

10. The signal processing system according to any one of claims 1 to 3, wherein the frequency mixing and phase shifting unit comprises:
a third phase shifting unit and a third frequency mixing unit;
the third phase shifting unit is configured to perform phase shifting processing on the first baseband signal to obtain N first phase-shifted signals, and perform phase shifting processing on the second baseband signal to obtain N second phase-shifted signals; and
the third frequency mixing unit is configured to separately perform frequency mixing processing on the N first phase-shifted signals and the N second phase-shifted signals, to obtain the N radio frequency signals.

11. The signal processing system according to claim 10, wherein the third phase shifting unit comprises:
2N phase shifters;
a (2i-1)^{th} phase shifter in the 2N phase shifters is configured to separately perform phase shifting processing on N baseband sub-signals corresponding to the first baseband signal to obtain the N first phase-shifted signals;
a 2i^{th} phase shifter in the 2N phase shifters is configured to separately perform phase shifting processing on N baseband sub-signals corresponding to the second baseband signal to obtain the N second phase-shifted signals; and
i is a positive integer less than or equal to N.

12. The signal processing system according to claim 10 or 11, wherein the third frequency mixing unit comprises N frequency mixing modules, and a third frequency mixing module in the N frequency mixing modules comprises:
a fifth frequency mixer and a sixth frequency mixer;
the fifth frequency mixer is configured to perform frequency mixing processing on a first local-oscillator signal and one first phase-shifted signal of the N first phase-shifted signals; and
the sixth frequency mixer is configured to perform frequency mixing processing on the first local-oscillator signal and one second phase-shifted signal of the N second phase-shifted signals.

13. The signal processing system according to any one of claims 1 to 3, wherein the frequency mixing and phase shifting unit comprises:
a fourth frequency mixing unit and a fifth frequency mixing unit;
the fourth frequency mixing unit is configured to: separately perform frequency mixing processing on each second local-oscillator signal of N second local-oscillator signals, a quadrature signal corresponding to each second local-oscillator signal, and N baseband sub-signals corresponding to the first baseband signal, to obtain N first frequency-mixed signals; and is configured to: separately perform frequency mixing processing on each second local-oscillator signal of the N second local-oscillator signals, the quadrature signal corresponding to each second local-oscillator signal, and N baseband sub-signals corresponding to the second baseband signal, to obtain N second frequency-mixed signals; and
the fifth frequency mixing unit is configured to separately perform frequency mixing processing on the N first frequency-mixed signals and the N second frequency-mixed signals to obtain the N radio frequency signals.

14. The signal processing system according to claim 13, wherein frequencies of all second local-oscillator signals in the N second local-oscillator signals are different from each other.

15. The signal processing system according to claim 13 or 14, wherein the fourth frequency mixing unit comprises 2N frequency mixing modules, and a fourth frequency mixing module in the 2N frequency mixing modules comprises:
a seventh frequency mixer and an eighth frequency mixer;
the seventh frequency mixer is configured to perform frequency mixing processing on one second local-oscillator signal of the N second local-oscillator signals and a first baseband sub-signal corresponding to the first baseband signal;
the eighth frequency mixer is configured to perform frequency mixing processing on a quadrature signal corresponding to the one second local-oscillator signal and the first baseband sub-signal corresponding to the first baseband signal;
a fifth frequency mixing module in the 2N frequency mixing modules comprises:
a ninth frequency mixer and a tenth frequency mixer;
the ninth frequency mixer is configured to perform frequency mixing processing on one second local-oscillator signal of the N second local-oscillator signals and a second baseband sub-signal corresponding to the second baseband signal; and
the tenth frequency mixer is configured to perform frequency mixing processing on a quadrature signal corresponding to the one second local-oscillator signal and the second baseband sub-signal corresponding to the second baseband signal.

16. The signal processing system according to any one of claims 13 to 15, wherein the fifth frequency mixing unit comprises N frequency mixing modules, and a sixth frequency mixing module in the N frequency mixing modules comprises:
an eleventh frequency mixer and a twelfth frequency mixer;
the eleventh frequency mixer is configured to perform frequency mixing processing on a first local-oscillator signal and one first frequency-mixed signal of the N first frequency-mixed signals; and
the twelfth frequency mixer is configured to perform frequency mixing processing on the first local-oscillator signal and one second frequency-mixed signal of the N second frequency-mixed signals.

17. The signal processing system according to any one of claims 1 to 16, wherein the signal generation unit comprises:
a first digital-to-analog converter and a second digital-to-analog converter;
the first digital-to-analog converter is configured to perform digital-to-analog conversion on an input first digital signal, to obtain the first baseband signal; and
the second digital-to-analog converter is configured to perform digital-to-analog conversion on an input second digital signal, to obtain the second baseband signal.

18. The signal processing system according to any one of claims 1 to 16, wherein the signal generation unit comprises:
a first phase shifter and a second phase shifter;
the first phase shifter is configured to perform phase shifting processing on an input first digital signal and a third local-oscillator signal to obtain the first baseband signal; and
the second phase shifter is configured to perform phase shifting processing on an input second digital signal and the third local-oscillator signal to obtain the second baseband signal.

19. A chip, wherein the chip comprises the signal processing system according to any one of claims 1 to 18.

20. A radar, wherein the radar comprises the signal processing system according to any one of claims 1 to 18, or the chip according to claim 19.

21. A terminal device, wherein the terminal device comprises the signal processing system according to any one of claims 1 to 18, or the chip according to claim 19, or the radar according to claim 20.

22. A vehicle, wherein the vehicle comprises the signal processing system according to any one of claims 1 to 18, or the chip according to claim 19, or the radar according to claim 20, or the terminal device according to claim 21.
